(19) Europäisches Patentamt
European Patent Office
Office européen des brevets

(11) **EP 3 913 694 B1**

(12) **EUROPEAN PATENT SPECIFICATION**

(45) Date of publication and mention
of the grant of the patent:
**23.04.2025 Bulletin 2025/17**

(21) Application number: **19910489.4**

(22) Date of filing: **25.11.2019**

(51) International Patent Classification (IPC):
*H01L 25/075* (2006.01)      *H01L 33/44* (2010.01)
*H01L 33/62* (2010.01)      *H01L 33/00* (2010.01)
*H01L 33/20* (2010.01)

(52) Cooperative Patent Classification (CPC):
**H10H 20/84; H01L 25/0753; H10H 20/01;**
H10H 20/819; H10H 20/857

(86) International application number:
**PCT/KR2019/016248**

(87) International publication number:
**WO 2020/149515 (23.07.2020 Gazette 2020/30)**

(54) **DISPLAY DEVICE AND MANUFACTURING METHOD THEREFOR**

ANZEIGEVORRICHTUNG UND HERSTELLUNGSVERFAHREN DAFÜR

DISPOSITIF D'AFFICHAGE ET SON PROCÉDÉ DE FABRICATION

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **15.01.2019 KR 20190005429**

(43) Date of publication of application:
**24.11.2021 Bulletin 2021/47**

(73) Proprietor: **Samsung Display Co., Ltd.
Gyeonggi-do 17113 (KR)**

(72) Inventors:
• **DO, Young Rag**
**Seoul 05502 (KR)**
• **YOO, Hee Yeon**
**Seoul 06742 (KR)**
• **EO, Yun Jae**
**Seoul 02783 (KR)**

(74) Representative: **Marks & Clerk LLP
15 Fetter Lane
London EC4A 1BW (GB)**

(56) References cited:
KR-A- 20080 102 638      KR-A- 20140 051 009
US-A1- 2002 005 294      US-A1- 2013 027 623
US-A1- 2016 211 245      US-A1- 2018 019 369
US-A1- 2018 019 369

• JIAN LU ET AL: "High-Efficient Chip to Wafer
Self-Alignment and Bonding Applicable to
MEMS-IC Flexible Integration", IEEE SENSORS
JOURNAL, IEEE, USA, vol. 13, no. 2, 14 January
2013 (2013-01-14), pages 651 - 656, XP011487777,
ISSN: 1530-437X, DOI: 10.1109/
JSEN.2012.2225422
• EO, YUN JAE ET AL.: "Enhanced DC-operated
electroluminescence of forwardly aligned p/
MQW/n InGaN nanorod LEDs via DC offset-AC
dielectrophoresis", ACS APPLIED MATERIALS &
INTERFACES, 11 October 2017 (2017-10-11),
pages 1 - 33, XP055725516

## Description

### [Technical Field]

The present invention relates to a display device and a manufacturing method thereof.

### [Background Art]

With the development of multimedia, display devices are becoming more important. In response to the development, various types of display devices, such as organic light emitting diode (OLED) display devices, liquid crystal display (LCD) devices, and the like, are being used.

A device for displaying an image of a display device includes a display panel such as an OLED panel or an LCD panel. Among the above panels, a light emitting display panel may include a light emitting element. For example, an LED includes an OLED using an organic material as a fluorescent material, and an inorganic LED using an inorganic material as a fluorescent material.

The inorganic LED using an inorganic semiconductor as a fluorescent material has durability in a high temperature environment and has an advantage of high efficiency of blue light as compared with the OLED. Further, even in a manufacturing process which has been pointed out as a limitation of the conventional inorganic LED element, a transfer method using dielectrophoresis (DEP) has been developed. Therefore, research is being carried out on inorganic LEDs having excellent durability and excellent efficiency as compared with OLEDs.

US2018/019369 A1 describes a display apparatus including a substrate, a first electrode on the substrate, the first electrode including a first portion that has a flat upper surface and a second portion that protrudes from the first portion and has an inclined surface, a second electrode facing the first electrode in parallel on the substrate, the second electrode including a first portion that has a flat upper surface and a second portion that protrudes from the first portion and has an inclined surface, and a plurality of light-emitting devices separate from each other on the first electrode and the second electrode, the light-emitting devices each having a first end contacting the upper surface of the first portion of the first electrode and a second end contacting the upper surface of the first portion of the second electrode.

US 2016/211245 A1 describes a display including a nano-scale LED and a method for manufacturing the same. In detail, nano-scale LED devices, each of which has a nano unit, are connected to nano-scale electrodes without electrical short-circuit to overcome a limitation in which it is difficult to allow nano-scale LED devices according to the related art to stand up and be coupled to electrodes and a limitation in which it is difficult to allow the nano-scale LED devices to be one-to-one coupled to the nano-scale electrodes different from each other, thereby realizing a display including the nano-scale LEDs. Also, the display may have superior light extraction efficiency and prevent defective pixels and the defect of the whole display due to the defects of the nano-scale LED devices, which may rarely occur, from occurring to minimize the defects of the display including the nano-scale LEDs and maintain its original function.

US 2002/005294 A1 describes an electro-fluidic assembly process for integration of an electronic device or component onto a substrate which comprises: disposing components within a carrier fluid; attracting the components to an alignment sites on the substrate by means of electrophoresis or dielectrophoresis; and aligning the components within the alignment site by means of energy minimization. The substrate comprises: a biased backplane layer, a metal plane layer having one or more alignment sites, a first insulating layer disposed between the backplane layer and the metal plane layer, and a second insulating layer, e.g., benzocyclobute, having a recess disposed therein, wherein the second insulating layer is on the surface of the metal plane layer opposite from the first insulating layer and wherein the recess is in communication with the alignment site.

Jian Le et al., "High-Efficient Chip to Wafer Self-Alignment and Bonding Applicable to MEMS-IC Flexible Integration", IEEE Sensors Journal, IEEE, USA, Vol:13, no..2, describes a flexible approach for chip to wafer high-accurate alignment and bonding developed using a self-assembled monolayer (SAM). In this approach, a hydrophobic SAM, FDTS ($CF_3(CF_2)_7(CH_2)_2SiCl_3$), is successfully patterned by lift-off process on an oxidized silicon wafer to define the binding-sites. A certain volume of $H_2O$ ($\mu/mm^2$) is dropped and then spread on the non-coated hydrophilic $SiO_2$ binding-sites for self-alignment of various microelectromechanical systems (MEMS) and IC chips by capillary force of $H_2O$. Our results demonstrate that reasonably high alignment speed (in milliseconds) and excellent alignment accuracy ($\leq 1 \mu m$) are achieved when the difference in the measured contact angle between hydrophobic FDTS and hydrophilic binding-sites is >;70°. It is also found that the hydrophilic frame at the edge of each binding-site is effective in achieving successful self-alignment, while a super fine pattern at the center of the binding-site can be used to control the bonding strength. The effects of the Au/Cr thin film pattern on self-alignment are studied and discussed in this paper to enable the application of the above approach in various MEMS-IC integration processes, especially for low-cost mass production of wireless sensor nodes.

### [Disclosure]

### [Technical Problem]

The present invention is directed to providing a method of manufacturing a display device, which includes forming a spreading prevention layer on an electrode to spray a solvent, in which light emitting elements are dispersed, on the spreading prevention layer, thereby arranging the light emitting elements.

The present invention is also directed to providing a display device including light emitting elements sprayed on the spreading prevention layer and disposed between electrodes.

It should be noted that objects of the present invention are not limited to the above-described objects, and other objects of the present invention will be apparent to those skilled in the art from the following descriptions.

**[Technical Solution]**

According to a first aspect of the disclosure, there is provided a display device according to the appended claims.

According to an example, a display device comprises: a substrate in which a first area and a second area, which is an area other than the first area, are defined, a first electrode and a second electrode disposed and at least partially spaced apart from each other in the first area on the substrate, a coating layer disposed to cover at least a portion of each of the first electrode and the second electrode on the substrate, and at least one light emitting element disposed between the first electrode and the second electrode in the first area, wherein the coating layer includes an opening exposing at least a portion of each of the first electrode and the second electrode and includes a first coating layer which is disposed in an area except for the opening and which includes a hydrophobic material.

The first coating layer may be disposed to at least overlap the first area, and the light emitting element may be disposed in an area in which the opening is not disposed on the first coating layer.

The first coating layer may be disposed to cover the first electrode and the second electrode which are disposed in the first area, and the opening may be disposed on the first coating layer and includes a first opening exposing at least a portion of the first electrode and the second electrode of the first area.

The display device may further comprise: a first contact electrode in contact with the first electrode exposed through the first opening, and a second contact electrode in contact with the second electrode exposed through the first opening, wherein the first contact electrode may be in contact with one end portion of the light emitting element and the second contact electrode may be in contact with the other end portion thereof.

The first coating layer may be disposed in a gap region in which the first electrode and the second electrode are spaced apart from each other and partially overlap facing side surfaces of the first electrode and the second electrode.

The first coating layer may include at least one coating pattern, and the coating pattern may be disposed on a first side surface at which the first electrode is opposite to the second electrode and disposed on a second side surface at which the second electrode is opposite to the first electrode.

At least a portion of each of the first electrode and the second electrode may be disposed in the second area, and the first coating layer may be disposed to cover the first electrode and the second electrode in the second area.

The coating layer may include a second coating layer disposed in the first area, and the light emitting element may be disposed on the second coating layer.

The first coating layer may include a polymer containing fluorine.

The second coating layer may be disposed to cover the first electrode and the second electrode which are disposed in the first area, and the opening may be disposed on the second coating layer and further include a second opening exposing at least a portion of each of the first electrode and the second electrode of the first area.

The second coating layer may be disposed in a gap region between the first electrode and the second electrode which are disposed in the first area.

The second coating layer may be disposed to partially overlap facing side surfaces of the first electrode and the second electrode.

According to another embodiment, a method of manufacturing a display device comprises: preparing a target substrate and a first electrode and a second electrode which are spaced apart from each other on the target substrate, forming a coating layer which is disposed on at least a partial area of the target substrate and which covers at least a portion of each of the first electrode and the second electrode, and spraying an ink including a light emitting element on the coating layer covering the first electrode and the second electrode and landing the light emitting element between the first electrode and the second electrode.

The coating layer includes a material having a first polarity, and the ink includes a solvent having a second polarity opposite to the first polarity.

The first polarity is hydrophobic and the second polarity is hydrophilic, and the coating layer may contain a fluorine-based polymer.

The ink may be sprayed onto the coating layer on the first electrode and the second electrode, and the ink sprayed onto the coating layer may have a contact angle of 30 degrees or more between the ink and the coating layer.

The landing of the light emitting element may include applying alternating-current (AC) power to the first electrode and the second electrode to form an electric field in the ink, and arranging the light emitting element between the first electrode and the second electrode due to the electric field.

The details of other embodiments are included in the detailed description and the accompanying drawings.

[Advantageous Effects]

In accordance with a method of manufacturing a display device according to an embodiment, a coating layer having a polarity opposite, being hydrophobic, to a polarity, being hydrophilic, of an ink including a light emitting element can be formed, and the coating layer can prevent the ink from spreading from an area in which the ink is sprayed. Consequently, in a manufacturing process of the display device, a position of the ink can be maintained at a position in the area in which the ink is sprayed, and the light emitting element can be disposed between electrodes in a specific area.

In addition, in accordance with a display device according to an embodiment, the number of light emitting elements disposed in an alignment area can be increased to improve a process yield and light emission reliability for each pixel.

The effects according to the embodiments are not limited by the contents exemplified above, and more various effects are included in this disclosure.

[Description of Drawings]

FIG. 1 is a plan view illustrating a display device according to one embodiment.

FIG. 2 is a schematic diagram illustrating a light emitting element according to one embodiment.

FIG. 3 is a schematic cross-sectional view illustrating the display device according to one embodiment.

FIG. 4 is a schematic diagram illustrating that an ink is sprayed onto an electrode according to Comparative Example.

FIG. 5 is a cross-sectional view taken along line IIa-IIa' of FIG. 4.

FIG. 6 is a schematic diagram illustrating that an ink is sprayed onto an electrode on which a coating layer is formed according to one embodiment.

FIG. 7 is a cross-sectional view taken along line IIb-IIb' of FIG. 6.

FIGS. 8 and 9 are schematic cross-sectional views illustrating a display device according to another embodiment.

FIG. 10 is a cross-sectional view taken along line I-I' of FIG. 1.

FIG. 11 is a flowchart illustrating a method of manufacturing a display device according to one embodiment;

FIGS. 12 to 16 are cross-sectional views illustrating processes of a method of manufacturing a display device according to one embodiment.

FIGS. 17 to 20 are plan views illustrating the display device according to another embodiment.

FIG. 21 is a schematic cross-sectional view illustrating that an ink is sprayed onto the display device of FIG. 19.

FIG. 22 is a plan view illustrating a display device according to still another embodiment.

FIG. 23 is a schematic cross-sectional view illustrating that an ink is sprayed onto the display device of FIG. 22.

FIG. 24 is a plan view illustrating a display device according to yet another embodiment.

FIG. 25 is a schematic cross-sectional view illustrating that an ink is sprayed onto the display device of FIG. 24.

FIGS. 26 to 27 are plan views illustrating a display device according to yet another embodiment.

FIG. 28 is a schematic diagram of a light emitting element according to another embodiment.

[Modes of the Invention]

The present invention will now be described more fully hereinafter with reference to the accompanying drawings, in which preferred embodiments of the invention are shown. This invention may, however, be embodied in different forms and should not be construed as limited to the embodiments set forth herein. Rather, these embodiments are provided so that this disclosure will be thorough and complete, and will fully convey the scope of the invention to those skilled in the art.

It will also be understood that when a layer is referred to as being "on" another layer or substrate, it can be directly on the other layer or substrate, or intervening layers may also be present. The same reference numbers indicate the same components throughout the specification.

It will be understood that, although the terms "first," "second," etc. may be used herein to describe various elements, these elements should not be limited by these terms. These terms are only used to distinguish one element from another element. For instance, a first element discussed below could be termed a second element without departing from the teachings of the present invention. Similarly, the second element could also be termed the first element.

Hereinafter, embodiments of the present invention will be described with reference to the accompanying drawings.

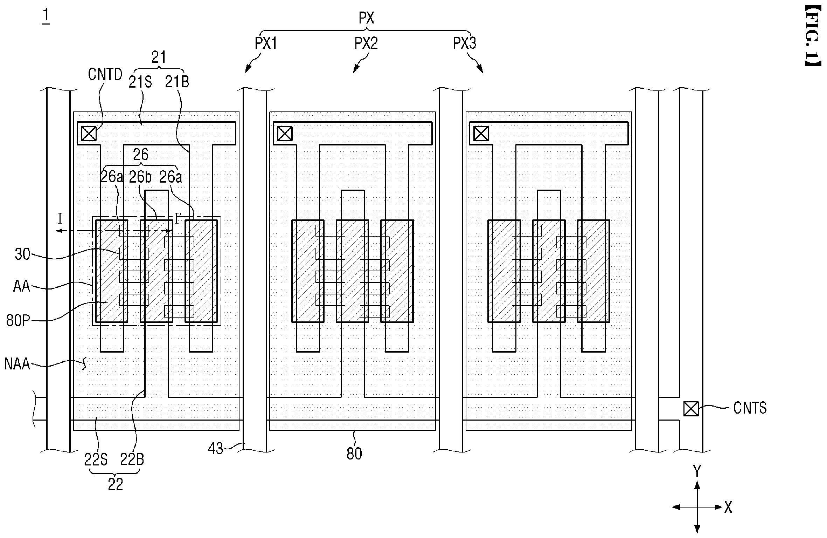

FIG. 1 is a plan view illustrating a display device according to one embodiment.

Referring to FIG. 1, a display device 1 includes a plurality of pixels PX. Each pixel PX includes one or more light emitting elements 30, which emit light in a specific wavelength range, to display a specific color.

Each pixel PX may include a first sub-pixel PX1, a second sub-pixel PX2, and a third sub-pixel PX3. The first sub-pixel PX1 may emit light of a first color, the second sub-pixel PX2 may emit light of a second color, and the third sub-pixel PX3 may emit light of a third color. The first color may be a red color, the second color may be a green color, and the third color may be a blue color, but the present invention is not limited thereto, and the sub-pixels PXn may emit light of the same color. In addition, although each pixel PX has been illustrated as including three sub-pixels in FIG. 1, the present invention is not limited thereto, and each pixel PX may include a larger number of sub-pixels.

Meanwhile, in this disclosure, terms "first," "second," and the like are used to refer to each of the components, but these are used to simply distinguish the components from each other and do not necessarily refer to a corresponding component. That is, the components defined as first, second, and the like are not necessarily limited to a specific structure or location and, in some cases, other numbers may be assigned to the components. Therefore, the number assigned to each component may be described through the drawings and the following description, and a first component mentioned below may be a second component within the technical idea of the present invention.

Each sub-pixel PXn of the display device 1 may include an area defined as an alignment area AA and an area defined as a non-alignment area NAA. The alignment area AA is defined as an area in which the light emitting elements 30 included in the display device 1 are disposed. The non-alignment area NAA may be an area other than the alignment area AA and defined as an area in which the light emitting elements 30 are not disposed and light is not emitted.

However, the definition of the alignment area AA is not limited thereto and may be defined as an area in which the light emitting elements 30 should be disposed. In other words, the alignment area AA in which the light emitting elements 30 should be aligned is defined on each pixel PX or each sub-pixel PXn, and in the manufacturing process of the display device 1, the light emitting elements 30 may be disposed in the alignment area AA. In an example, the alignment area AA may include electrodes 21 and 22 of each sub-pixel PXn and may be defined as an area between the electrodes 21 and 22.

The display device 1 includes a coating layer 80 disposed on at least a partial region of each pixel PX or each sub-pixel PXn. The coating layer 80 is disposed in the alignment area AA or the non-alignment area NAA of each sub-pixel PXn, and the coating layer 80 partially overlap the electrodes 21 and 22. FIG. 1 illustrates that the coating layer 80 is disposed in each sub-pixel PXn to entirely cover the electrodes 21 and 22 and includes an opening 80P which exposes some region of each sub-pixel PXn. The coating layer 80 may include the alignment area AA and may be partially disposed even in the non-alignment area NAA. However, the present invention is not limited thereto.

As described below, in the manufacturing process of the display device 1, the coating layer 80 distributes an ink S in which the light emitting elements 30 are dispersed to the electrodes 21 and 22 and applies an electric field to the ink S so that the light emitting elements 30 may be disposed on the electrodes 21 and 22. The coating layer 80 according to one embodiment may perform a function of preventing the ink S sprayed on each pixel PX or each sub-pixel PXn from moving or spreading to an area other than a required alignment area AA. Owing to the coating layer 80, the ink S may be sprayed into the required alignment area AA, and the light emitting elements 30 may be smoothly disposed on the electrodes 21 and 22. A detailed description thereof will be made below.

The sub-pixel PXn of the display device 1 may include a plurality of banks 40, a plurality of electrodes 21 and 22, the light emitting elements 30, and the coating layer 80.

The plurality of electrodes 21 and 22 may be electrically connected to the light emitting elements 30 and may receive a predetermined voltage so as to allow the light emitting elements 30 to emit light. In addition, in order to align the light emitting elements 30, at least a portion of each of the electrodes 21 and 22 may be utilized to form an electric field in the sub-pixel PXn.

The plurality of electrodes 21 and 22 includes a first electrode 21 and a second electrode 22. In an example, the first electrode 21 may be a pixel electrode which is separated in each sub-pixel PXn, and the second electrode 22 may be a common electrode which is commonly connected along the sub-pixels PXn. One of the first electrode 21 and the second electrode 22 may be an anode electrode of the light emitting element 30, and the other thereof may be a cathode electrode of the light emitting element 30. However, the present invention is not limited thereto and the reverse of the above description may be possible.

The first electrode 21 and the second electrode 22 may include electrode stem portions 21S and 22S disposed to extend in a first direction X-axis and include electrode branch portions 21B and 22B extending and branching from the electrode stem portions 21S and 22S in a second direction Y-axis intersecting the first direction X-axis.

The first electrode 21 may include a first electrode stem portion 21S disposed to extend in the first direction X-axis, and at least one first electrode branch portion 21B branching from the first electrode stem portion 21S to extend in the second direction Y-axis.

Two ends of the first electrode stem portion 21S of any one pixel may be separated to be terminated between the sub-pixels PXn and disposed to be substantially collinear with a first electrode stem portion 21S of an adjacent sub-pixel PXn (e.g., a subpixel which is adjacent in the first direction X-axis) belonging to the same row. Thus, the first electrode stem portion 21S disposed in each sub-pixel PXn may apply different electrical signals to first electrode branch portions 21B, and the first electrode branch portions 21B may be driven separately.

The first electrode branch portion 21B branches from at least a portion of the first electrode stem portion 21S and is disposed to extend in the second direction Y-axis. The first electrode branch portion 21B may be terminated in a state of being separated from the second electrode stem portion 22S which is disposed opposite to the first electrode stem portion 21S.

The second electrode 22 may include the second electrode stem portion 22S which extends in the first direction X-axis and is disposed to be separated from and opposite to the first electrode stem portion 21S, and the second electrode branch portion 22B which branches from the second electrode stem portion 22S and is disposed to extend in the second direction Y-axis. However, one end portion of the second electrode stem portion 22S may extend to a plurality of adjacent sub-pixels PXn in the first direction X-axis. Thus, the two ends of the second electrode stem portion 22S of any one pixel may be connected to a second electrode stem portion 22S of an adjacent pixel PX among the pixels PX.

The second electrode branch portion 22B may be separated from and opposite to the first electrode branch portion 21B and terminated in a state of being separated from the first electrode stem portion 21S. That is, one end portion of the second electrode branch portion 22B may be connected to the second electrode stem portion 22S, and the other end portion thereof may be disposed in the sub-pixel PXn in a state of being separated from the first electrode stem portion 21S.

In the drawing, two first electrode branch portions 21B have been illustrated as being disposed and the second electrode branch portion 22B has been illustrated as being disposed between the two first electrode branch portions 21B, but the present invention is not limited thereto.

The plurality of banks 40 includes a third bank 43 disposed at a boundary between the sub-pixels PXn, and a first bank 41 and a second bank 42 which are disposed below the electrodes 21 and 22. Although the first bank 41 and the second bank 42 are not illustrated in the drawing, the first bank 41 and the second bank 42 are disposed below the first electrode branch portion 21B and the second electrode branch portion 22B, respectively.

The third bank 43 may be disposed at a boundary between the sub-pixels PXn. End portions of the plurality of first electrode stem portions 21S may be separated from each other to be terminated based on the third bank 43. The third bank 43 may extend in the second direction Y-axis and may be disposed at the boundary between the sub-pixels PXn disposed in the first direction X-axis. However, the present invention is not limited thereto, and the third bank 43 may extend in the first direction X-axis and may be disposed even at the boundary between the sub-pixel PXn disposed in the second direction Y-axis. The third bank 43 may include the same material as the first bank 41 and the second bank 42 and may be formed in substantially the same process.

Although not shown in the drawing, a first insulating layer 51 is disposed in each sub-pixel PXn to entirely cover each sub-pixel PXn including the first electrode branch portion 21B and the second electrode branch portion 22B. The first insulating layer 51 may protect each of the electrodes 21 and 22 and, simultaneously, insulate the electrodes 21 and 22 from each other so as not to be in direct contact with each other.

The plurality of light emitting elements 30 are disposed between the first electrode branch portion 21B and the second electrode branch portion 22B. One end portions of at least some of the plurality of light emitting elements 30 may be electrically connected to the first electrode branch portion 21B and the other end portions thereof electrically connected to the second electrode branch portion 22B.

The plurality of light emitting elements 30 may be separated from each other in the second direction Y-axis and disposed substantially parallel to each other. A separation gap between the light emitting elements 30 is not particularly limited. In some cases, the plurality of light emitting elements 30 may be disposed adjacent to each other to form a group, and a plurality of other light emitting elements 30 may be grouped in a state of being spaced at regular intervals from each other, may have a nonuniform density, and may be oriented and aligned in one direction.

The contact electrode 26 may be disposed on the first electrode branch portion 21B and the second electrode branch portion 22B. However, the contact electrode 26 may be substantially disposed on the first insulating layer 51, and at least a portion of the contact electrode 26 may be in contact with or electrically connected to the first electrode branch portion 21B and the second electrode branch portion 22B.

A plurality of contact electrodes 26 may be disposed to extend in the second direction Y-axis and disposed to be separated from each other in the first direction X-axis. The contact electrode 26 may be in contact with at least one end portion of the light emitting element 30, and the contact electrode 26 may be in contact with the first electrode 21 or the second electrode 22 to receive an electrical signal. Thus, the contact electrode 26 may transmit an electrical signal, which is transmitted from each of the electrodes 21 and 22, to the light emitting element 30.

The contact electrode 26 may include a first contact electrode 26a and a second contact electrode 26b. The first contact electrode 26a may be disposed on the first electrode branch portion 21B to be in contact with one end portion of the light emitting element 30, and the second contact electrode 26b may be disposed on the second electrode branch portion 22B to be in contact with the other end portion thereof.

The first electrode stem portion 21S and the second electrode stem portion 22S may be electrically connected to a circuit element layer of the display device 1 through contact holes, for example, a first electrode contact hole CNTD and a second electrode contact hole CNTS. In the drawing, one second electrode contact hole CNTS has been illustrated as being formed in the second electrode stem portion 22S of each of the plurality of sub-pixels PXn. However, the present invention is not limited thereto, and in some cases, the second electrode contact hole CNTS may be formed in each sub-pixel PXn.

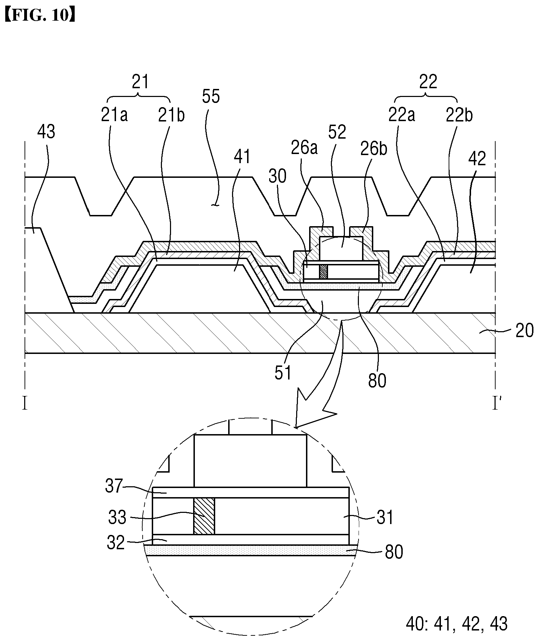

In addition, although not shown in the drawing, the display device 1 may include a second insulating layer 52 (see FIG. 10) and a passivation layer 55 (see FIG. 10) which are disposed to cover at least a portion of each of the electrodes 21 and 22 and the light emitting element 30. An arrangement and structures thereof will be described below.

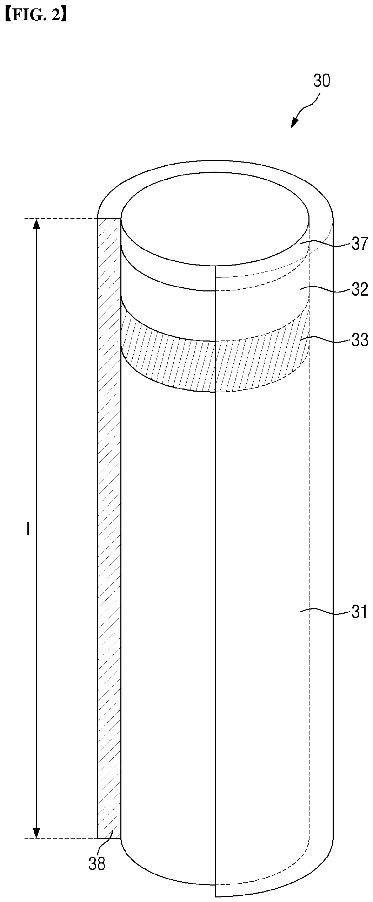

FIG. 2 is a schematic diagram illustrating the light emitting element 30 according to one embodiment.

The light emitting element 30 may be an LED. Specifically, the light emitting element 30 may be an inorganic LED having a micrometer unit or nanometer unit size and made of an inorganic material. The inorganic light emitting diode may be aligned between two electrodes in which polarity is formed by forming an electric field in a specific direction between the two electrodes facing each other. The light emitting element 30 may be aligned between two electrodes due to an electric field formed on the two electrodes.

The light emitting element 30 may include a semiconductor crystal doped with an arbitrary conductivity type (e.g., p-type or n-type) impurity. The semiconductor crystal may receive an electrical signal applied from an external power source and emit light in a specific wavelength range.

Referring to FIG. 2, the light emitting element 30 according to one embodiment may include a first conductivity type semiconductor 31, a second conductivity type semiconductor 32, an active layer 33, and an insulating film 38. In addition, the light emitting element 30 according to one embodiment may further include at least one conductive electrode layer 37. Although the light emitting element 30 has been illustrated as further including one conductive electrode layer 37 in FIG. 2, the present invention is not limited thereto. In some cases, the light emitting element 30 may include a greater number of conductive electrode layers 37 or the conductive electrode layer 37 may be omitted. A description of the light emitting element 30, which will be made below, may be identically applied even when the number of conductive electrode layers 37 is varied or another structure is further included.

The light emitting element 30 may have a shape extending in one direction. The light emitting element 30 may have a shape of nanorods, nanowires, nanotubes, or the like. In an embodiment, the light emitting element 30 may be a cylindrical shape or a rod shape. However, the shape of the light emitting element 30 is not limited thereto and may have various shapes such as a regular hexahedral shape, a rectangular parallelepiped shape, a hexagonal column shape, and the like. A plurality of semiconductors included in the light emitting element 30, which will be described below, may have a structure in which the semiconductors are sequentially disposed or stacked in the one direction.

The light emitting element 30 according to one embodiment may emit light in a specific wavelength range. In an example, the active layer 33 may emit blue light having a central wavelength range ranging from 450 nm to 495 nm. However, the central wavelength range of the blue light is not limited to the above range, and it should be understood that the central wavelength range includes all wavelength ranges which can be recognized as a blue color in the art. Further, the light emitted from the active layer 33 of the light emitting element 30 is not limited thereto, and the light may be green light having a central wavelength range ranging from 495 nm to 570 nm or red light having a central wavelength range ranging from 620 nm to 750 nm.

To describe the light emitting element 30 in detail with reference to FIG. 2, the first conductivity type semiconductor 31 may be an n-type semiconductor having, for example, a first conductivity type. For example, when the light emitting element 30 emits light in a blue wavelength range, the first conductivity type semiconductor 31 may include a semiconductor material having a chemical formula of $In_xAl_yGa_{1-x-y}N$ ($0 \leq x \leq 1$, $0 \leq y \leq 1$, and $0 \leq x+y \leq 1$). For example, the semiconductor material may be one or more among InAlGaN, GaN, AlGaN, InGaN, AlN, and InN which are doped with an n-type impurity. The first conductivity type semiconductor 31 may be doped with a first conductive dopant. For example, the first conductivity type dopant may be Si, Ge, Sn, or the like. In an example, the first conductivity type semiconductor 31 may be n-GaN doped with n-type Si. A length of the first conductivity type semiconductor 31 may range from 1.5 $\mu$m to 5 $\mu$m, but the present invention is not limited thereto.

The second conductivity type semiconductor 32 is disposed on the active layer 33 which will be described below. For example, the second conductivity type semiconductor 32 may be a p-type semiconductor having a second conductivity type. For example, when the light emitting element 30 emits light in a blue or green wavelength range, the second conductivity type semiconductor 32 may include a semiconductor material having a

chemical formula of $In_xAl_yGa_{1-x-y}N(0 \leq x \leq 1, 0 \leq y \leq 1$, and $0 \leq x+y \leq 1)$. For example, the semiconductor material may be one or more among InAlGaN, GaN, AlGaN, InGaN, AlN, and InN which are doped with a p-type impurity. The second conductivity type semiconductor 32 may be doped with a second conductive dopant. For example, the second conductive dopant may be Mg, Zn, Ca, Se, Ba, or the like. In an example, the second conductivity type semiconductor 32 may be p-GaN doped with p-type Mg. A length of the second conductivity type semiconductor 32 may range from 0.08 $\mu$m to 0.25 $\mu$m, but the present invention is not limited thereto.

Meanwhile, in the drawing, although each of the first conductivity type semiconductor 31 and the second conductivity type semiconductor 32 has been illustrated as being formed as one layer, the present invention is not limited thereto. In some cases, each of the first conductivity type semiconductor 31 and the second conductivity type semiconductor 32 may further include a larger number of layers, for example, a clad layer or a tensile strain barrier reducing (TSBR) layer according to a material of the active layer 33.

The active layer 33 is disposed between the first conductivity type semiconductor 31 and the second conductivity type semiconductor 32. The active layer 33 may include a material having a single or multiple quantum well structure. When the active layer 33 includes a material having a multiple quantum well structure, the active layer 330 may have a structure in which a plurality of quantum layers and a plurality of well layers are alternately stacked. The active layer 33 may emit light due to a combination of electron-hole pairs in response to an electrical signal applied through the first conductivity type semiconductor 31 and the second conductivity type semiconductor 32. As an example, when the active layer 33 emits light in a blue wavelength range, the active layer 33 may include a material such as AlGaN, AlInGaN, or the like. In particular, when the active layer 33 has a multi-quantum well structure in which quantum layers and well layers are alternately stacked, the quantum layer may include a material such as AlGaN or AlInGaN, and the well layer may include a material such as GaN or AlInN. In an example, the active layer 33 includes AlGaInN as the quantum layer and AlInN as the well layer. As described above, the active layer 33 may emit blue light having a central wavelength range ranging from 450 nm to 495 nm.

However, the present invention is not limited thereto, and the active layer 33 may have a structure in which a semiconductor material having large band gap energy and a semiconductor material having small band gap energy are alternately stacked or include different Group III to V semiconductor materials according to a wavelength range of emitted light. The active layer 33 is not limited to emit light in the blue wavelength range, and in some cases, the active layer 33 may emit light in a red or green wavelength range. A length of the active layer 33 may range from 0.05 $\mu$m to 0.25 $\mu$m, but the present invention is not limited thereto.

Meanwhile, the light emitted from the active layer 33 may be emitted to an outer surface of the light emitting element 30 in a length direction and both side surfaces thereof. Directivity of the light emitted from the active layer 33 is not limited in one direction.

The conductive electrode layer 37 may be an ohmic contact electrode. However, the present invention is not limited thereto, and the conductive electrode layer 37 may be a Schottky contact electrode. The conductive electrode layer 37 may include a conductive metal. For example, the conductive electrode layer 37 may include at least one among aluminium (Al), titanium (Ti), indium (In), gold (Au), silver (Ag), indium tin oxide (ITO), indium zinc oxide (IZO), and indium tin-zinc oxide (ITZO). In addition, the conductive electrode layer 37 may include a semiconductor material doped with an n-type or p-type impurity. The conductive electrode layer 37 may include the same material or different materials, but the present invention is not limited thereto.

The insulating film 38 is disposed to surround the outer surfaces of the plurality of semiconductors which are described above. In an example, the insulating film 38 may be disposed to surround at least the outer surface of the active layer 33 and may extend in one direction in which the light emitting element 30 extends. The insulating film 38 may serve to protect the members. For example, the insulating film 38 may be formed to surround side surfaces of the members and to expose the both end portions of the light emitting element 30 in the length direction.

In the drawing, the insulating film 38 has been illustrated as being formed to extend in the length direction of the light emitting element 30 to cover from the first conductivity type semiconductor 31 to the conductive electrode layer 37, but the present invention in not limited thereto. The insulating film 38 covers only the outer surfaces of some semiconductor layers including the active layer 33 or covers only a portion of the outer surface of the conductive electrode layer 37 so that a portion of the outer surface of the conductive electrode layer 37 may be exposed.

A thickness of the insulating film 38 may range from 10 nm to 1.0 $\mu$m, but the present invention is not limited thereto. Preferably, the thickness of the insulating film 38 may be 40 nm.

The insulating film 38 may include materials having insulation properties, for example, silicon oxide ($SiO_x$), silicon nitride ($SiN_x$), silicon oxynitride ($SiO_xN_y$), aluminium nitride (AlN), aluminium oxide ($Al_2O_3$), and the like. Thus, it is possible to prevent an electrical short circuit which may occur when the active layer 33 is in direct contact with an electrode through which an electrical signal is transmitted to the light emitting element 30. In addition, since the insulating film 38 protects the outer surface of the light emitting element 30 including the active layer 33, it is possible to prevent degradation in light emission efficiency.

In addition, in some embodiments, the outer surface of the insulating film 38 may be surface treated. When the display device 1 is manufactured, the light emitting element 30 may be sprayed onto an electrode in a state of being dispersed in a predetermined ink to be aligned. Here, in order to allow the light emitting element 30 to be maintained in the dispersed state without being agglomerated with an adjacent other light emitting element 30 in the ink S, the insulating film 38 may be hydrophobically or hydrophilically treated.

Meanwhile, the light emitting element 30 may have a length l ranging from 1 μm to 10 μm or from 2 μm to 5 μm, and preferably, have the length l of about 4 μm. In addition, a diameter of the light emitting element 30 may range from 300 nm to 700 nm, and an aspect ratio of the light emitting element 30 may range from 1.2 to 100. However, the present invention is not limited thereto, and the plurality of light emitting elements 30 included in the display device 1 may have different diameters according to a difference in composition of the active layers 33. Preferably, the diameter of the light emitting element 30 may be about 500 nm.

As described above, the light emitting elements 30 may be sprayed onto the electrodes 21 and 22 in a state of being dispersed in the ink S. In order to allow the light emitting elements 30 to be disposed between the electrodes 21 and 22, it is required for the ink S to be located in the required alignment area AA. According to one embodiment, in the manufacturing process of the display device 1, the coating layer 80 disposed in at least a partial region of the pixel PX or the sub-pixel PXn may be formed, thereby preventing the ink S in which the light emitting elements 30 are dispersed from spreading from the alignment area AA.

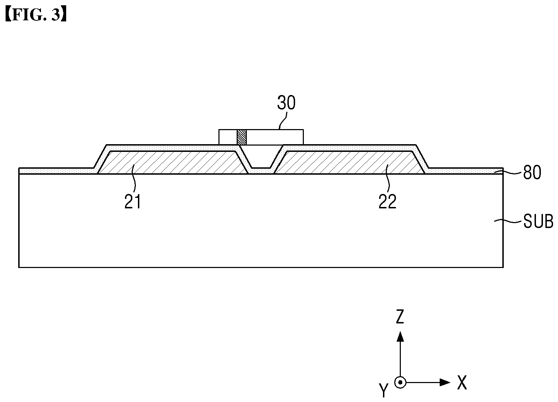

FIG. 3 is a schematic cross-sectional view illustrating the display device according to one embodiment.

Referring to FIGS. 1 and 3, the coating layer 80 may be disposed to entirely cover a target substrate SUB and the electrodes 21 and 22. The light emitting element 30 may be disposed on the coating layer 80 between the first electrode 21 and the second electrode 22. When the display device 1 is manufactured, the coating layer 80 disposed on the electrodes 21 and 22 may prevent the spread of the sprayed ink S to induce the light emitting element 30 to be disposed in the alignment area AA defined on the target substrate SUB.

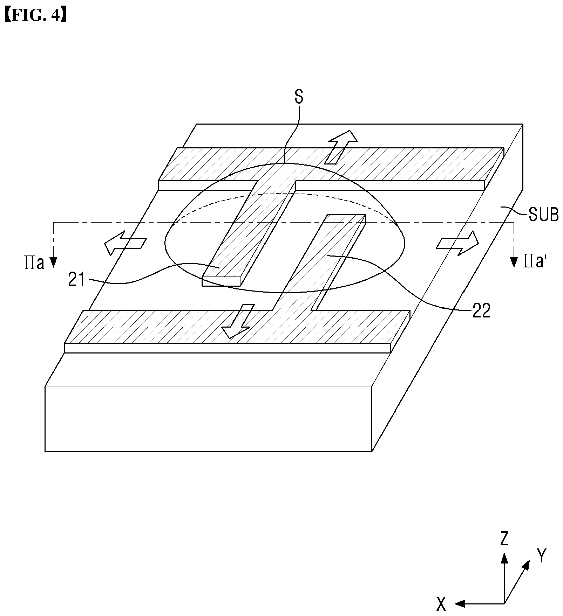

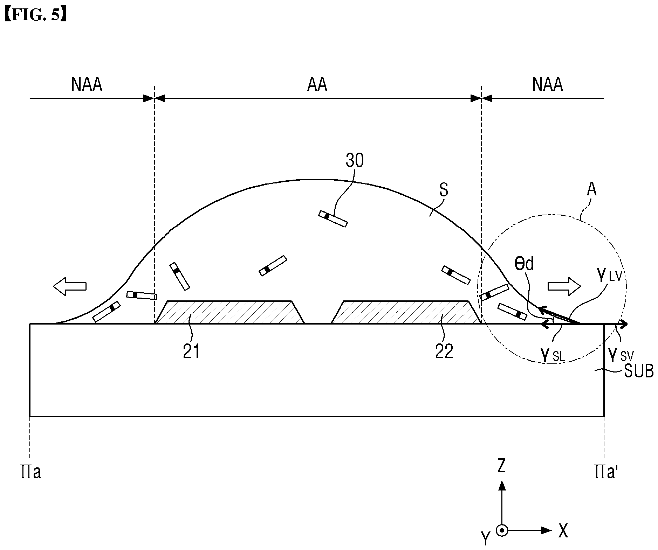

FIG. 4 is a schematic diagram illustrating that an ink is sprayed onto an electrode according to Comparative Example. FIG. 5 is a cross-sectional view taken along line IIa-IIa' of FIG. 4.

Referring to FIGS. 4 and 5, in order to arrange the light emitting elements 30 on the electrodes 21 and 22, the ink S in which the light emitting elements 30 are dispersed may be sprayed onto the target substrate SUB. The alignment area AA and a non-alignment area NAA are defined on the target substrate SUB, and the ink S is sprayed onto the electrodes 21 and 22 in the alignment area AA. However, as shown in the drawings, when the coating layer 80 is not formed on the target substrate SUB, the ink S sprayed onto the target substrate SUB moves in at least one direction, and particularly, the ink S deviates from the alignment area AA to spread to the non-alignment area NAA. Thus, occupation of light emitting elements 30 located in the non-alignment area NAA among the light emitting elements 30 dispersed in the ink S is increased, and when an electric field is formed in the ink S in an operation, which will be described below, the number of the light emitting elements 30 disposed between the electrodes 21 and 22 in the alignment area AA is decreased. In this case, in the manufacturing process of the display device 1, a manufacturing yield is decreased and a defective rate of the manufactured display device 1 is increased.

On the other hand, in the manufacturing process of the display device 1 according to one embodiment, the coating layer 80 is formed before the ink S is sprayed so that the ink S may be prevented from moving to an area other than the alignment area AA. That is, the display device 1 may include the coating layer 80 which performs a function of preventing spreading of ink S to induce the light emitting elements 30 to be smoothly disposed in the alignment area AA.

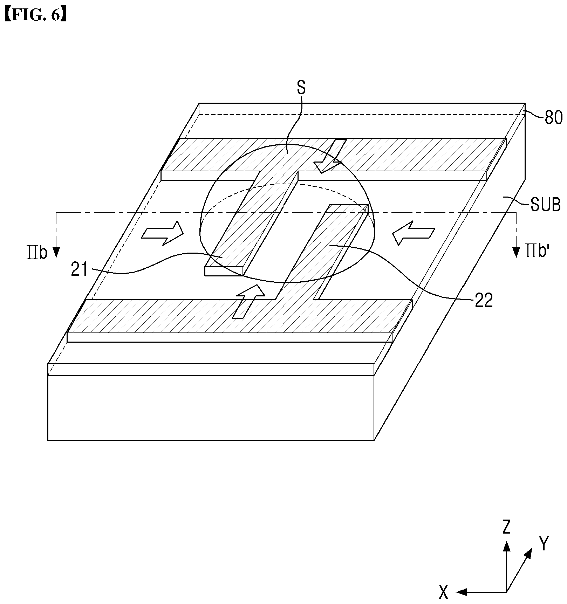

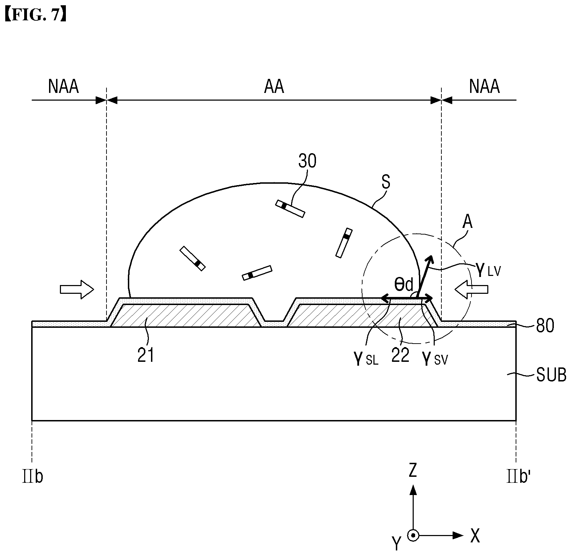

FIG. 6 is a schematic diagram illustrating that an ink is sprayed onto an electrode on which a coating layer is formed according to one embodiment. FIG. 7 is a cross-sectional view taken along line IIb-IIb' of FIG. 6.

Referring to FIGS. 6 and 7, the display device 1 according to one embodiment includes the coating layer 80 disposed on the target substrate SUB, for example, disposed to cover the first electrode 21 and the second electrode 22. The ink S in which the light emitting elements 30 are dispersed is sprayed onto the coating layer 80 in the alignment area AA.

The coating layer 80 may prevent the sprayed ink S from moving in at least one direction. The ink S sprayed onto the coating layer 80 may not spread in one direction and may be maintained at an initial sprayed position, and among the light emitting elements 30 dispersed in the ink S, occupation of light emitting elements 30 located in the alignment area AA may be increased. When an electric field is formed in the ink S in an operation which will be described below, most of the light emitting elements 30 dispersed in the ink S may be disposed between the electrodes 21 and 22 in the alignment area AA.

The spreading prevention function of the coating layer 80 may be induced by controlling a contact angle $\theta d$ using a difference in surface energy between the coating layer 80 and a solvent of the ink S. According to one embodiment, the ink S in which the light emitting elements 30 are dispersed may include a solvent having a first polarity, and at least a partial region of the coating layer 80 may include a material having a second polarity opposite to the first polarity. The second polarity is hydrophobic.

As shown in FIGS. 5 and 7, the ink S sprayed onto the target substrate SUB may form a predetermined contact angle θd on an interface with the target substrate SUB or the coating layer 80. A liquid sprayed onto a target object may have a shape which minimizes surface energy of a surface of the liquid. The ink S sprayed onto the target substrate SUB or the coating layer 80 may have a spherical or semi-elliptical shape which minimizes surface energy on a surface of the ink S.

Here, as in portion A of FIGS. 5 and 7, surface energy may be formed on interfaces between the ink S and the target substrate SUB or the coating layer 80, between air and the target substrate SUB or the coating layer 80, and between the air and the ink S in one directions.

As in portion A of FIG. 5, first surface energy γSL is formed on the interface between the ink S and the target substrate SUB, a second surface energy γSV is formed on the interface between the target substrate SUB and the air, and third surface energy γLV is formed on the interface between the ink S and air. When a contact angle θd is formed between a surface of the ink S and the target substrate SUB, a relationship therebetween satisfies the following equation 1.

[Equation 1]

$$\gamma SV - \gamma SL - \gamma LV \cos(\theta d) = 0$$

(Here, γSL is the first surface energy, γSV is the second surface energy, γLV is the third surface energy, and θd is the contact angle between the surface of the ink S and the target substrate SUB)

To describe with reference to Equation 1 and FIG. 5, when an γSL value which is the first surface energy is smaller than an γSV value which is the second surface energy, the ink S may exhibit a behavior so as to minimize surface energy of the interface. That is, a force is applied to the ink S at a point at which the ink S is in contact with the target substrate SUB in one direction of a transverse direction in which the second surface energy γSV having a large value is applied, and the surface of the ink S may move in the one direction. Thus, the contact angle θd between the ink S and the target substrate SUB is decreased, and the ink S spreads in the one direction on the target substrate SUB.

On the other hand, to describe with reference to Equation 1 and FIG. 7, when the ink S is sprayed onto the coating layer 80, and when the γSL value that is the first surface energy is greater than the γSV value that is the second surface energy, in order to minimize surface energy of the interface, a force may be applied to the ink S in the one direction of the transverse direction to which the first surface energy γSL having a large value is applied. Thus, the contact angle θd between the ink S and the coating layer 80 may be increased, and the ink S may be maintained at the first sprayed position without moving on the coating layer 80.

The coating layer 80 may control a difference between the first surface energy γSL and the second surface energy γSV from the ink S. For example, the ink S may be sprayed onto the coating layer 80, and thus the first surface energy γSL may have a value greater than a value of the second surface energy γSV on the interface between the coating layer 80 and the ink S. In this case, the force acts in a direction to which the first surface energy γSL is directed so that the coating layer 80 may induce the surface energy of the ink S to have a small value and may prevent the ink S from spreading.

The coating layer 80 according to one embodiment includes a material having a polarity opposite to a polarity of the solvent of ink S, and thus the first surface energy γSL and the contact angle θd between the coating layer 80 and the ink S may each have a large value. The coating layer 80 may prevent the ink S sprayed on the alignment area AA from spreading to the non-alignment area NAA.

The solvent of the ink S is hydrophilic, and at least a portion of the coating layer 80 includes a hydrophobic material. Thus, the contact angle θd between the coating layer 80 and the ink S may have a value of 30° or more. As the coating layer 80 includes a hydrophobic material, the hydrophobic material may be a polymer including fluorine (F). As an example, the coating layer 80 may include 1H,1H,2H,2H-perfluorodecyltrichlorosilane. In addition, some regions of the coating layer 80 may have the same polarity as the ink S, and the remaining regions of the coating layer 80 may have a polarity opposite to a polarity of the ink S.

For example, the coating layer 80 may include a first region and a second region which have different polarities, and the ink S may be sprayed between the first and second regions. In this case, when the surface energy of the ink S is increased as the interface between the ink S and the coating layer 80 is changed from the first region to the second region, the coating layer 80 may prevent the ink S from moving to the second region. That is, it is possible to prevent the ink S from spreading from the first region to the second region on the coating layer 80. A description thereof will be made below with reference to other drawings.

Meanwhile, as described above, the display device 1 may further include a contact electrode 26 in contact with the light emitting element 30 and the electrodes 21 and 22. The contact electrode 26 may be in contact with at least one end portion of the light emitting element 30 and may be in contact with regions of the electrodes 21 and 22 in which the coating layer 80 is partially removed to be exposed.

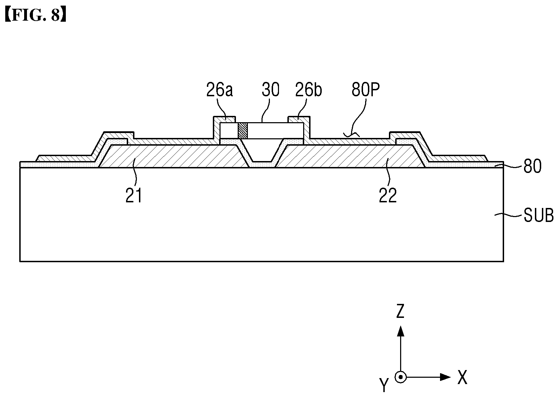

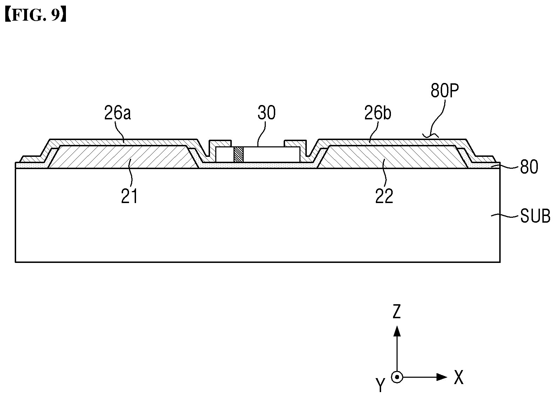

FIGS. 8 and 9 are schematic cross-sectional views illustrating a display device according to another embodiment.

First, referring to FIG. 8, the coating layer 80 includes the opening 80P which exposes at least a portion of each of the electrodes 21 and 22 and may further include the contact electrode 26 in contact with the electrodes 21 and 22 which are exposed through the opening 80P. The coating layer 80 may be disposed to cover the electrodes 21 and 22, and the opening 80P overlaps the electrodes 21 and 22 to expose a partial region of each of the electrodes 21 and 22. An area in which the opening 80P is disposed is an area in which the coating layer 80 partially exposes upper surfaces of the electrodes 21 and 22 in FIG. 1. As shown in the drawings, the opening 80P may partially expose the upper surfaces of the electrodes 21 and 22, but the present invention is not limited thereto. As described below with reference to FIG. 9, the opening 80P may entirely expose flat upper surfaces of the electrodes 21 and 22 and may partially expose inclined side surfaces of the electrodes 21 and 22.

The contact electrode 26 is disposed on the electrodes 21 and 22. The contact electrode 26 may be in contact with the light emitting element 30 and the regions of the electrodes 21 and 22 which are exposed through the opening 80P. The contact electrode 26 includes a first contact electrode 26a disposed on the first electrode 21 and a second contact electrode 26b disposed on the second electrode 22. The first contact electrode 26a may be in contact with the exposed region of the first electrode 21 and one end portion of the light emitting element 30, and the second contact electrode 26b may be contact with the exposed region of the second electrode 22 and the other end portion of the light emitting element 30.

In the manufacturing process of the display device 1, the coating layer 80 may be formed to entirely cover the target substrate SUB and the electrodes 21 and 22 to dispose the light emitting element 30 in the alignment area AA, and the opening 80P may be formed to expose a portion of each of the electrodes 21 and 22. Even when the coating layer 80 entirely covers the electrodes 21 and 22, since the display device 1 further includes the contact electrode 26 in contact with the light emitting element 30 and the electrodes 21 and 22 exposed through the opening 80P, electrical signals transmitted from the electrodes 21 and 22 may be transmitted to the light emitting element 30 through the contact electrode 26.

Referring to FIG. 9, the opening 80P of the coating layer 80 may expose at least a portion of a side surface, including the upper surface, of each of the electrodes 21 and 22. Areas of the electrodes 21 and 22 exposed by the opening 80P are increased, and the contact electrode 26 may be in contact with the electrodes 21 and 22 in a larger region. Thus, contact resistance between the contact electrode 26 and the electrodes 21 and 22 may be reduced. However, the structure of the display device 1 is not limited thereto, and the display device 1 may have a structure different from the above structure or a larger number of members may be disposed on the target substrate SUB. A description thereof will be made with reference to other drawings.

Hereinafter, the display device 1 will be described in detail with reference to other drawings.

FIG. 10 is a partial cross-sectional view taken along line I-I' of FIG. 1.

FIG. 10 illustrates the cross-sectional view of the first sub-pixel PX1 and may be equally applied to other pixels PX or other sub-pixels PXn. FIG. 6 illustrates a cross section crossing one end portion and the other end portion of an arbitrary light emitting element 30.

Meanwhile, although not shown in FIG. 10, the display device 1 may further include a circuit element layer located below the electrodes 21 and 22. The circuit element layer may include a plurality of semiconductor layers and a plurality of conductive patterns and may include at least one transistor and a power line. However, a detailed description thereof will be omitted below.

To describe the display device 1 in detail with reference to FIG. 10, the display device 1 may include a via layer 20, the electrodes 21 and 22 disposed on the via layer 20, and the light emitting element 30. A circuit element layer (not shown) may be further disposed below the via layer 20. The via layer 20 may include an organic insulating material and perform a surface planarization function.

A plurality of banks 41, 42, and 43 are disposed on the via layer 20. The plurality of banks 41, 42, and 43 may be disposed to be separated from each other in each sub-pixel PXn. The plurality of banks 41, 42, and 43 may include the first bank 41 and the second bank 42 which are disposed adjacent to a central portion of the sub-pixel PXn, and the third bank 43 disposed at a boundary between the sub-pixels PXn.

When an ink S is sprayed using an inkjet printing device during the manufacturing of the display device 1, the third bank 43 may perform a function of blocking the ink S from crossing the boundary of the sub-pixel PXn. In addition, when the display device 1 further includes other members, the other members may be disposed on the third bank 43, and the third bank 43 may perform a function of supporting the other members. However, the present invention is not limited thereto.

The first bank 41 and the second bank 42 are disposed to be separated from and opposite to each other. The first electrode 21 is disposed on the first bank 41, and the second electrode 22 is disposed on the second bank 42. Referring to FIGS. 2 and 6, it can be understood that the first electrode branch portion 21B is disposed on the first bank 41, and the second bank 42 is disposed on the second bank 42.

As described above, the first bank 41, the second bank 42, and the third bank 43 may be formed substantially in the same process. Thus, the banks 41, 42, and 43 may constitute a single grid pattern. Each of the plurality of banks 41, 42, and 43 may include polyimide (PI).

Each of the plurality of banks 41, 42, and 43 may have a structure in which at least a portion protrudes from the via layer 20. The banks 41, 42, and 43 may protrude upward from a flat surface on which the light emitting element 30 is disposed, and at least a part of each of the protruding portions may have a slope. A shape of each of the banks 41, 42, and 43 having the protruding structures is not particularly limited. As shown in the drawing, the first bank 41 and the second bank 42 protrude to the same height, and the third bank 43 may have a shape protruding to a higher position.

Reflective layers 21a and 22a may be disposed on the first bank 41 and the second bank 42, and electrode layers 21b and 22b may be disposed on the reflective layers 21a and 22a. The reflective layers 21a and 22a and the electrode layers 21b and 22b may constitute the electrodes 21 and 22.

The reflective layers 21a and 22a include a first reflective layer 21a and a second reflective layer 22a. The first reflective layer 21a may cover the first bank 41, and the second reflective layer 22a may cover the second bank 42. Portions of the reflective layers 21a and 22a are electrically connected to the circuit element layer through a contact hole passing through the via layer 20.

Each of the reflective layers 21a and 22a may include a material having high reflectance to reflect light emitted from the light emitting element 30. For example, each of the reflective layers 21a and 22a may include a material such as Ag, Cu, ITO, IZO, or ITZO, but the present invention is not limited thereto.

The electrode layers 21b and 22b include a first electrode layer 21b and a second electrode layer 22b. The electrode layers 21b and 22b may have patterns substantially equal to patterns of the reflective layers 21a and 22a. The first reflective layer 21a and the first electrode layer 21b are disposed to be separated from the second reflective layer 22a and the second electrode layer 22b.

Each of the electrode layers 21b and 22b includes a transparent conductive material, and thus light emitted from the light emitting element 30 may be incident on the reflective layers 21a and 22a. For example, each of the electrode layers 21b and 22b may include a material such as ITO, IZO, or ITZO, but the present invention is not limited thereto.

In some embodiments, the reflective layers 21a and 22a and the electrode layers 21b and 22b may form a structure in which one or more transparent conductive layers such as ITO, IZO, or ITZO, and one or more metal layers such as Ag or Cu are stacked. For example, the reflective layers 21a and 22a and the electrode layers 21b and 22b may form a stacked structure of ITO/Ag/ITO/IZO.

Meanwhile, in some embodiments, the first electrode 21 and the second electrode 22 may be formed as a single layer. That is, the reflective layers 21a and 22a and the electrode layers 21b and 22b may be formed as a single layer to transmit an electrical signal to the light emitting element 30 and, simultaneously, reflect light. For example, each of the first electrode 21 and the second electrode 22 may include a conductive material having high reflectance and may be an alloy containing Al, nickel (Ni), and lanthanum (La). However, the present invention is not limited thereto.

The first insulating layer 51 is disposed to partially cover the first electrode 21 and the second electrode 22. The first insulating layer 51 may be disposed to cover most of upper surfaces of the first electrode 21 and the second electrode 22 and may expose portions of the first electrode 21 and the second electrode 22. The first insulating layer 51 may be disposed to partially cover an area in which the first electrode 21 is separated from the second electrode 22 and an area opposite to the area in which the first electrode 21 is separated from the second electrode 22.

The first insulating layer 51 is disposed to expose relatively flat upper surfaces of the first electrode 21 and the second electrode 22 and disposed to allow the electrodes 21 and 22 to overlap inclined surfaces of the first bank 41 and the second bank 42. The first insulating layer 51 forms a flat upper surface to allow the light emitting element 30 to be disposed, and the flat upper surface extends toward the first electrode 21 and the second electrode 22 in one direction. The extension portion of the first insulating layer 51 is terminated at inclined surfaces of the first electrode 21 and the second electrode 22. Thus, the contact electrodes 26 may be in contact with the exposed first electrode 21 and the exposed second electrode 22 and may be in smooth contact with the light emitting element 30 on the flat upper surface of the first insulating layer 51.

The first insulating layer 51 may protect the first electrode 21 and the second electrode 22 and, simultaneously, insulate the first electrode 21 from the second electrode 22. In addition, the first insulating layer 51 may prevent the light emitting element 30 disposed thereon from being damaged by direct contact with other members.

The coating layer 80 is disposed on the first insulating layer 51. The coating layer 80 may have substantially the same shape as the first insulating layer 51 in a cross section. The above shape may be formed such that a material constituting the first insulating layer 51 and a material constituting the coating layer 80 are sequentially disposed on the electrodes 21 and 22 in the manufacturing process of the display device 1 and then etched in the same process. The opening 80P of the coating layer 80 may be formed in a region in which the first insulating layer 51 and the coating layer 80 are etched, thereby exposing some regions of the electrodes 21 and 22. Some regions of the electrodes 21 and 22 exposed through the opening 80P may be in contact with the contact electrode 26 which will be described below. However, the present invention is not limited thereto, and the coating layer 80 may be disposed in only a partial region on the first insulating layer 51 so that the coating layer 80 and the first insulating layer 51 may have different shapes. A description of the coating layer 80 is the same as the above description, and thus a detailed description thereof will be omitted herein. In addition, various examples of the coating layer 80 will be described below with reference to other drawings.

The light emitting element 30 may be disposed on the coating layer 80 or the first insulating layer 51. In the drawing, the light emitting element 30 is shown as being disposed on the coating layer 80 which is disposed on the first insulating layer 51. At least one light emitting element 30 may be disposed on the coating layer 80 between the first electrode 21 and the second electrode 22. The light emitting element 30 may include a plurality of layers disposed in a direction horizontal to the via layer 20.

The light emitting element 30 of the display device 1 according to one embodiment may include the conductive semiconductors and the active layer, which are described above, and the conductive semiconductors and the active layer may be sequentially disposed on the via layer 20 in the transverse direction. As shown in the drawing, in the light emitting element 30, the first conductivity type semiconductor 31, the active layer 33, the second conductivity type semiconductor 32, and the conductive electrode layer 37 may be sequentially disposed on the via layer 20 in the horizontal direction. However, the present invention is not limited thereto. The order of the plurality of layers disposed in the light emitting element 30 may be the opposite. In some cases, when the light emitting element 30 has another structure, the plurality of layers may be disposed in a direction perpendicular to the via layer 20.

The second insulating layer 52 may be partially disposed on the light emitting element 30. The second insulating layer 52 may protect the light emitting element 30 and, simultaneously, perform a function of fixing the light emitting element 30 during a process of manufacturing the display device 1. The second insulating layer 52 may be disposed to surround an outer surface of the light emitting element 30. That is, a portion of a material of the second insulating layer 52 may be disposed between a bottom surface of the light emitting element 30 and the first insulating layer 51. The second insulating layer 52 may extend between the first electrode branch portion 21B and the second electrode branch portion 22B in the second direction Y-axis to have an island shape or a linear shape when viewed in a plan view.

The contact electrodes 26 are disposed on the electrodes 21 and 22 and the second insulating layer 52. The first contact electrode 26a and the second contact electrode 26b are disposed to be spaced apart from each other on the second insulating layer 52. Thus, the second insulating layer 52 may insulate the first contact electrode 26a from the second contact electrode 26b.

The first contact electrode 26a may be in contact with at least the first electrode 21, which is exposed due to patterning of the first insulating layer 51 and the coating layer 80 and may be in contact with one end portion of the light emitting element 30. The second contact electrode 26b may be in contact with at least the second electrode 22, which is exposed due to the patterning of the first insulating layer 51 and the coating layer 80 and may be in contact with the other end portion of the light emitting element 30. The first and second contact electrodes 26a and 26b may be in contact with side surfaces of the two end portions of the light emitting element 30, for example, the first conductivity type semiconductor 31, the second conductivity type semiconductor 32, or the conductive electrode layer 37. As described above, the first insulating layer 51 forms the flat upper surface so that the contact electrodes 26 may be in smooth contact with the side surfaces of the light emitting element 30.

The contact electrode 26 may include a conductive material. For example, the contact electrode 260 may include ITO, IZO, ITZO, Al, or the like. However, the present invention is not limited thereto.

The passivation layer 55 is disposed above the second insulating layer 52 and the contact electrode 26. The passivation layer 55 may serve to protect members disposed on the via layer 20 from an external environment.

Each of the first insulating layer 51, the second insulating layer 52, and the passivation layer 55, which are described above, may include an inorganic insulating material or an organic insulating material. In an example, each of the first insulating layer 51, the second insulating layer 52, and the passivation layer 55 may include a material such as $SiO_x$, $SiN_x$, $SiO_xN_y$, $Al_2O_3$, aluminium nitride (AlN), or the like. The second insulating layer 52 may be made of an organic insulating material including a photoresist or the like. However, the present invention is not limited thereto.

Hereinafter, a method of manufacturing the display device 1 according to one embodiment will be described.

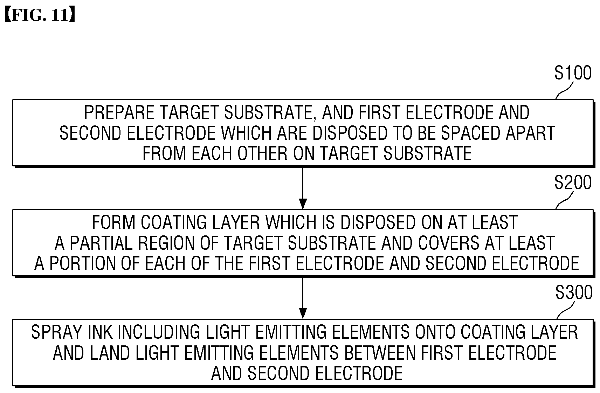

FIG. 11 is a flowchart illustrating a method of manufacturing a display device according to one embodiment.

Referring to FIG. 11, the method of manufacturing the display device 1 includes preparing a target substrate SUB and the first electrode 21 and the second electrode 22 which are disposed on the target substrate SUB (S100), forming the coating layer 80 disposed on at least a partial region of the target substrate SUB and configured to cover at least a portion of each of the first electrode 21 and the second electrode 22 (S200), and spraying the ink S including the light emitting elements 30 onto the coating layer 80 which covers the first electrode 21 and the second electrode 22 and landing the light emitting elements 30 between the first electrode 21 and the second electrode 22 (S300).

The method of manufacturing the display device 1 according to one embodiment includes preparing the first electrode 21 and the second electrode 22 which are disposed on the target substrate SUB, forming the coating layer 80 disposed on at least a partial region of the target substrate SUB, and then landing the light emitting elements 30 between the first electrode 21 and the second electrode 22. The coating layer 80 is disposed to partially overlap the electrodes 21 and 22 on the target substrate SUB, but the present invention is not limited thereto. In some cases, the coating layer 80 may be disposed only in a region other than the first electrode 21 and the second electrode 22. Hereinafter, an example in which the coating layer 80 entirely covers, including the first electrode 21 and the second electrode 22, the target substrate SUB will be described.

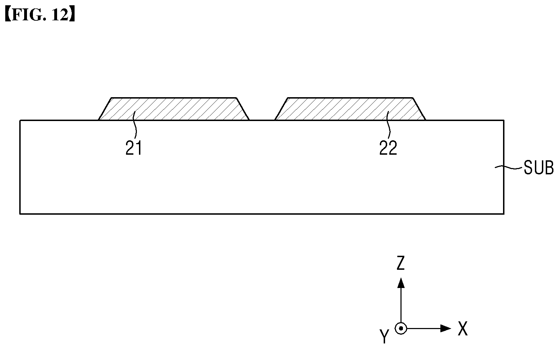

FIGS. 12 to 16 are cross-sectional views illustrating processes of the method of manufacturing a display device according to one embodiment.

First, as shown in FIG. 12, the target substrate SUB on which the first electrode 21 and the second electrode 22 are formed is prepared (S100). For convenience of description, in the following drawings, only the electrodes 21 and 22, the coating layer 80, and the light emitting elements 30, which are disposed on the target substrate SUB, are shown. However, the display device 1 is not limited thereto, and as described above, the display device 1 may include more members such as the bank 40, the contact electrode 26, and the like.

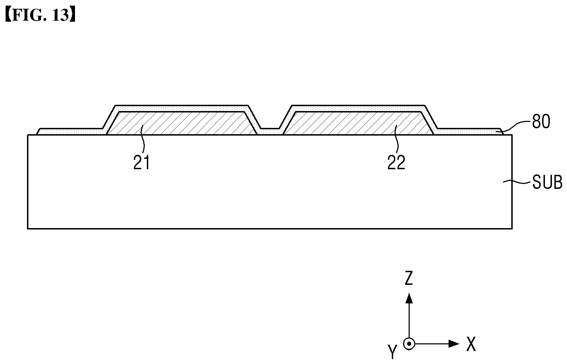

Next, as shown in FIG. 13, the coating layer 80 is formed to be disposed on the target substrate SUB and the electrodes 21 and 22 (S200). A method of forming the coating layer 80 is not particularly limited. In one embodiment, the coating layer 80 may include a self-assembly monolayer and may be formed on the electrodes 21 and 22. However, the present invention is not limited thereto.

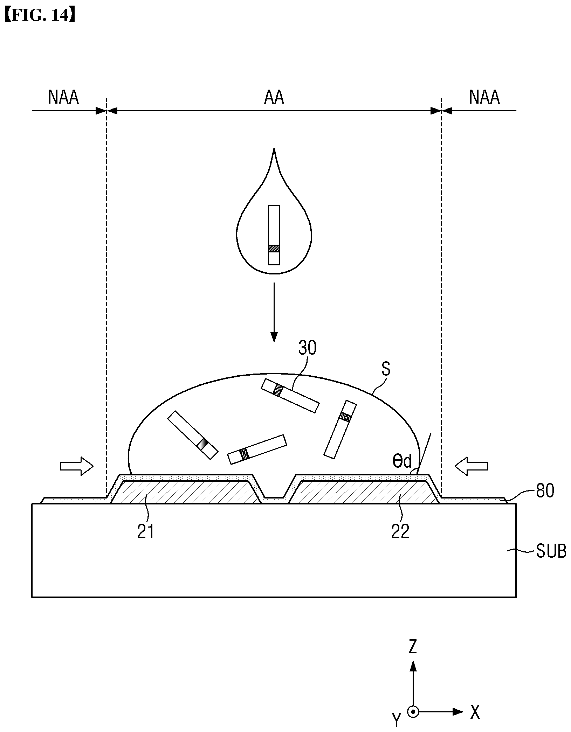

Next, as shown in FIG. 14, the ink S including the light emitting element 30 is sprayed onto the first electrode 21 and the second electrode 22. The ink S may be disposed on the coating layer 80 which is disposed to cover the first electrode 21 and the second electrode 22.

The ink S may include a solvent and a plurality of light emitting elements 30 included in the solvent. In an example, the ink S may be provided in a solution or colloidal state. For example, the solvent may be acetone, water, alcohol, toluene, propylene glycol (PG), or propylene glycol methyl acetate (PGMA), but the present invention is not limited thereto. For example, ink S may include hydrophilic PG as a solvent, and the coating layer 80 may include a hydrophobic fluorine-based polymer. That is, the ink S and the coating layer 80 may include materials having opposite polarities. The coating layer comprising a material having a hydrophobic polarity.

Thus, the first surface energy $\gamma$SL (not shown) formed on the interface between the coating layer 80 and the ink S has a large value, and the contact angle $\theta$d between the ink S and the coating layer 80 has a large value. The ink S sprayed on the coating layer 80 may be maintain at a first sprayed position without spreading in one direction. In particular, the ink S is sprayed in the alignment area AA defined on the first electrode 21 and the second electrode 22, and thus a large number of light emitting elements 30 may be located in the alignment area AA.

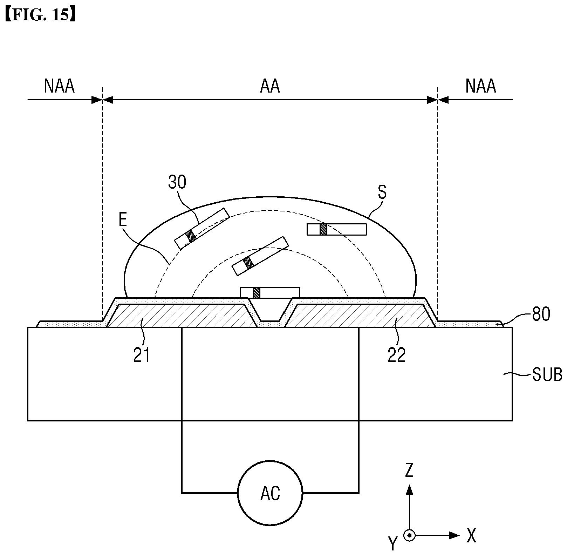

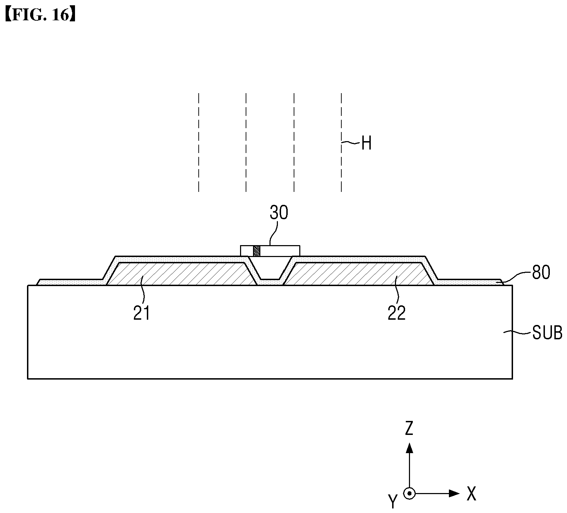

Next, as shown in FIGS. 15 and 16, the light emitting element 30 is landed between the first electrode 21 and the second electrode 22 (S300). The landing of the light emitting element 30 (S300) may include applying an electrical signal to the first electrode 21 and the second electrode 22 and forming an electric field in the ink S, applying a dielectrophoretic force to the light emitting element 30 due to the electric field and landing the light emitting element 30 on the electrodes 21 and 22, and removing the solvent of the ink S.

The light emitting element 30 may be disposed on the electrodes 21 and 22 using dielectrophoresis (DEP). The solution in which the light emitting elements 30 are dispersed is sprayed onto the electrodes 21 and 22, and alternating-current (AC) power is applied to the electrodes 21 and 22. When the AC power is applied to the first electrode 21 and the second electrode 22, an electric field is generated between the first electrode 21 and the second electrode 22, and the light emitting element 30 receiving a dielectrophoretic force due to the electric field may be disposed on the electrodes 21 and 22.

As shown in the drawing, when the AC power is applied to the electrodes 21 and 22, an electric field E may be formed in the ink S sprayed onto the electrodes 21 and 22. The electric field E may apply a dielectrophoretic force to the light emitting element 30, and the light emitting element 30 receiving the dielectrophoretic force may be landed on the first electrode 21 and the second electrode 22.

Next, when the light emitting element 30 is landed on the electrodes 21 and 22, the solvent of the ink S is removed. The removing of the solvent may employ a conventional method. For example, the solvent may be removed through a method such as a heat treatment method, an infrared irradiation method, or the like. The display device 1 including the coating layer 80 may be manufactured through the above processes. However, the method of manufacturing the display device 1 is not limited thereto. As described above, the display device 1 may include a larger number of members, and thus more processes may be performed. A detailed description thereof will be omitted herein.

Hereinafter, another embodiment of the display device 1 will be described with reference to other drawings.

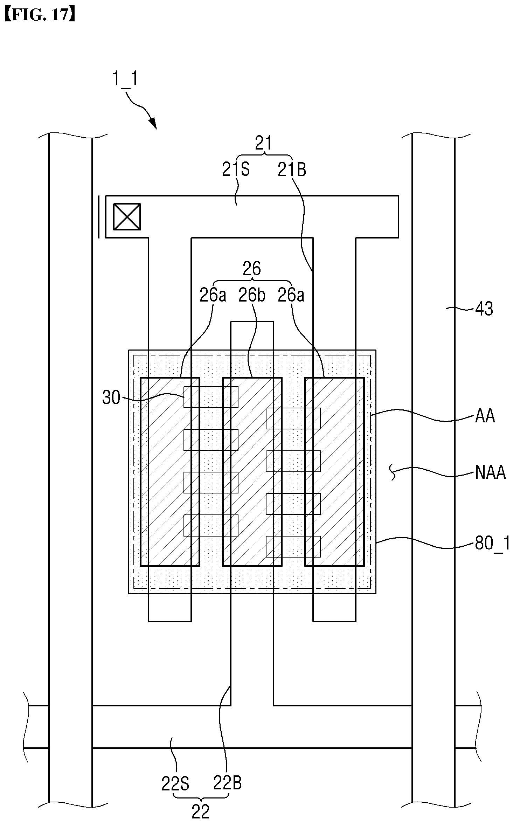

FIGS. 17 to 20 are plan views illustrating the display device according to another embodiment.

Referring to FIG. 17, a display device 1_1 according to one embodiment may be formed such that a coating layer 80_1 substantially overlaps the alignment area AA. In the display device 1_1 of FIG. 17, the coating layer 80_1 may be formed in a relatively narrow area when compared with the display device 1 of FIG. 1. Hereinafter, a duplicate description will be omitted and a description will be made to focus on a difference.

The coating layer 80_1 of the display device 1_1 may be disposed to overlap only an alignment area AA in which light emitting elements 30 are aligned. In the drawing, in order to distinguish the alignment area AA from the coating layer 80_1, boundaries of the alignment area AA and the coating layer 80_1 have been illustrated as being spaced apart from each other, but the coating layer 80_1 may overlap the alignment area AA. A first electrode branch portion 21B and a second electrode branch portion 22B may be disposed in the alignment area AA, and the coating layer 80_1 may be disposed to partially cover the first electrode branch portion 21B and the second electrode branch portion 22B.

When an ink S including the light emitting elements 30 is sprayed in only the alignment area AA in a manufacturing process of the display device 1_1, the coating layer 80_1 may be disposed on electrodes 21 and 22 overlapping the alignment area AA to prevent the ink S from spreading. The ink S disposed on the coating layer 80_1, which is disposed in the alignment area AA, may form first surface energy $\gamma$SL and a contact angle $\theta$d, each having a large value, on an interface between the ink S and the coating layer 80_1 and may be prevented from spreading to a non-alignment area NAA. Thus, a large number of light emitting elements 30 in the ink S may be located in the alignment area AA, and the light emitting elements 30 may be disposed between the electrodes 21 and 22 in the alignment area AA, that is, between the first electrode branch portion 21B and the second electrode branch portion 22B.

Meanwhile, the light emitting element 30 is disposed between the electrodes 21 and 22 opposite to each other in the alignment area AA. Each of the first electrode 21 and the second electrode 22 includes two side surfaces, and the light emitting element 30 is disposed between facing side surfaces of the first electrode 21 and the second electrode 22. That is, the ink S including the light emitting element 30 may be sprayed between the facing side surfaces of the electrodes 21 and 22. The coating layer 80 according to one embodiment may be disposed to overlap the electrodes 21 and 22 and disposed to overlap at least facing one side surfaces of the electrodes 21 and 22 and not to overlap the other side surfaces thereof.

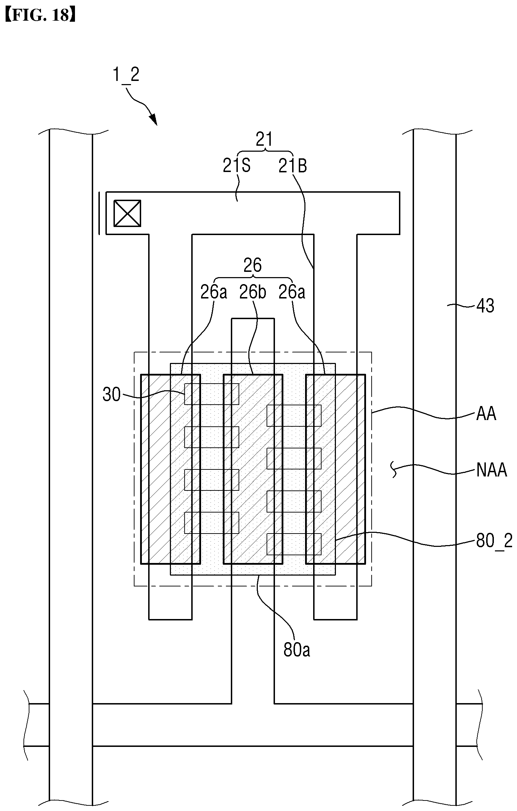

Referring to FIG. 18, a coating layer 80_2 of a display device 1_2 is disposed in an alignment area AA and disposed to partially overlap a first electrode branch portion 21B and a second electrode branch portion 22B. Two side surfaces of the second electrode branch portion 22B are opposite to different first electrode branch portions 21B, and thus the coating layer 80_2 overlaps the two side surfaces of the second electrode branch portion 22B. On the other hand, one side surface of the first electrode branch portion 21B, that is, one side surface located at an outer side on a central portion of the subpixel PXn in the drawing, is not opposite to the second electrode branch portion 22B.

According to one embodiment, each of the electrodes 21 and 22 may include one side surface and the other side surface, and the coating layer 80_2 may be disposed to overlap the one side surfaces of the electrodes 21 and 22 and disposed to not overlap the other side surfaces thereof. As shown in the drawing, the coating layer 80_2 is disposed to overlap one side surface of the first electrode branch portion 21B facing the second electrode branch portion 22B and disposed to not overlap of the other side surface of the first electrode branch portion 21B. An ink S may be sprayed on the coating layer 80_2 between the first electrode branch portion 21B and the second electrode branch portion 22B which faces each other, and the coating layer 80_2 may prevent the ink S from spreading to the other side surface of the first electrode branch portion 21B. Thus, most of the light emitting elements 30 in the ink S may be located between the first electrode branch portion 21B and the second electrode branch portion 22B.

Meanwhile, the coating layer 80 may be disposed in a region in which side surfaces of the electrodes 21 and 22 are opposite to each other and which is an area in which the light emitting elements 30 are disposed, and the coating layer 80 may form a plurality of coating patterns 80a to form a plurality of coating patterns 80a and may be disposed in opposite regions of the electrodes 21 and 22.

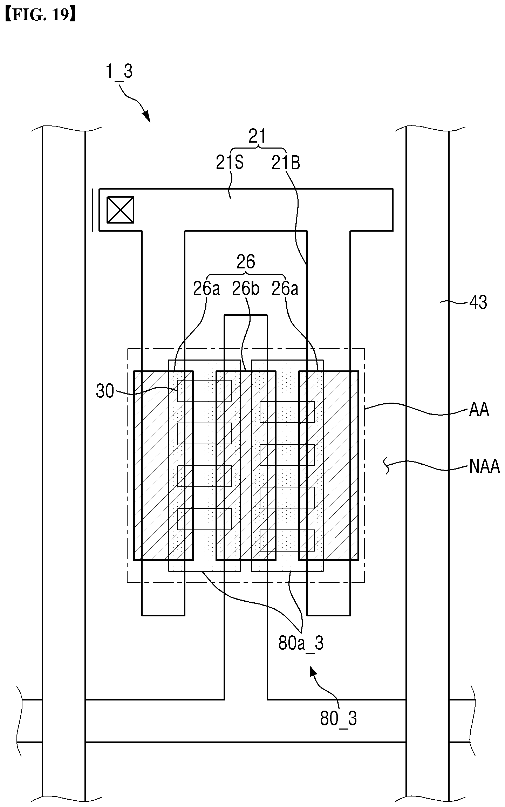

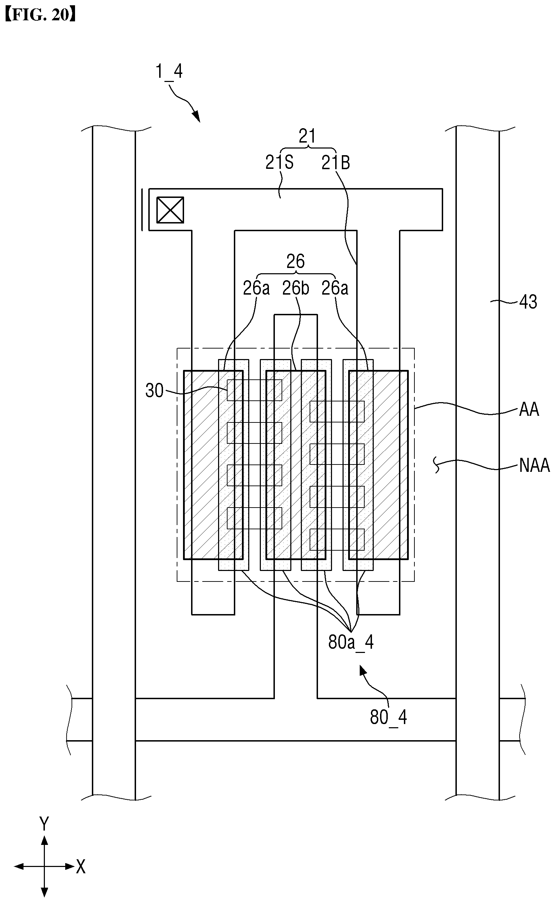

Referring to FIGS. 19 and 20, coating layers 80_3 and 80_4 of display devices 1_3 and 1_4 according to one embodiment include at least one coating pattern 80a_3 and at least one coating pattern 80a_4, and each of the coating patterns 80a_3 and 80a_4 may be disposed between the first electrode 21 and the second electrode 22. In the display device 1_3 of FIG. 19, one coating layer 80_3 may be disposed between a first electrode branch portion 21B and a second electrode branch portion 22B. In the display device 1_4 of FIG. 20, two coating layers 80_4 may be disposed to be spaced apart from each other between the first electrode branch portion 21B and the second electrode branch portion 22B.

Each of the coating patterns 80a_3 and 80a_4 may extend in the second direction Y-axis and may be disposed to be spaced apart in the first direction X-axis. The coating patterns 80a_3 and 80a_4 may partially overlap each of facing side surfaces of the first electrode branch portion 21B and the second electrode branch portion 22B and may also partially overlap a gap region in which the first electrode branch portion 21B is spaced apart from the second electrode branch portion 22B. The ink S including the light emitting elements 30 may be sprayed on the coating pattern 80a_3 of FIG. 19 or the coating pattern 80a_4 of FIG. 20 between the first electrode branch portion 21B and the second electrode branch portion 22B. The coating patterns 80a_3 and 80a_4 may prevent the ink S from spreading in a separated region between the first electrode branch portion 21B and the second electrode branch portion 22B.

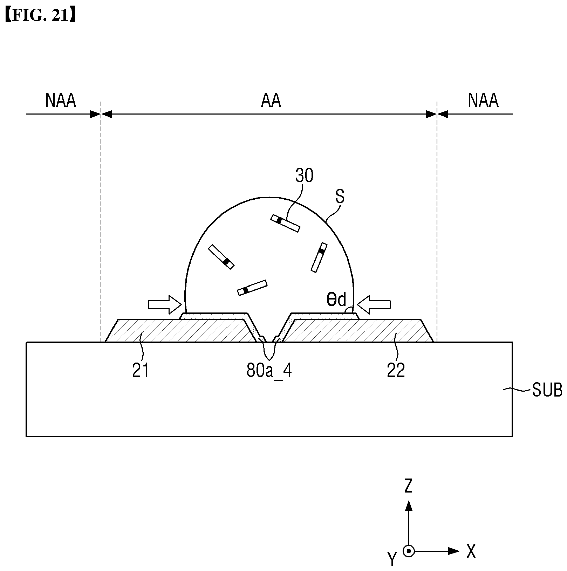

FIG. 21 is a schematic cross-sectional view illustrating that an ink is sprayed onto the display device of FIG. 20.

Specifically, referring to FIG. 21, the coating pattern 80a_4 is disposed to cover side surfaces of the first electrode 21 and the second electrode 22 opposite to each other and a region between the first electrode 21 and the second electrode 22. The ink S is sprayed onto the coating patterns 80a_4 of FIG. 20 between the first electrode 21 and the second electrode 22. A surface of the ink S sprayed onto the coating pattern 80a_4 may form a large contact angle θd on an interface with the coating pattern 80a_4 and may be prevented from spreading to an outer side of the coating pattern 80a_4. Thus, most of the light emitting elements 30 may be disposed between the first electrode 21 and the second electrode 22.

Meanwhile, when the ink S is sprayed in the alignment area AA, the coating layer 80 may not necessarily be disposed in the alignment area AA but may be disposed in only the non-alignment area NAA. The coating layer 80 disposed in the non-alignment area NAA may prevent the ink S sprayed in the alignment area AA from spreading to the non-alignment area NAA.

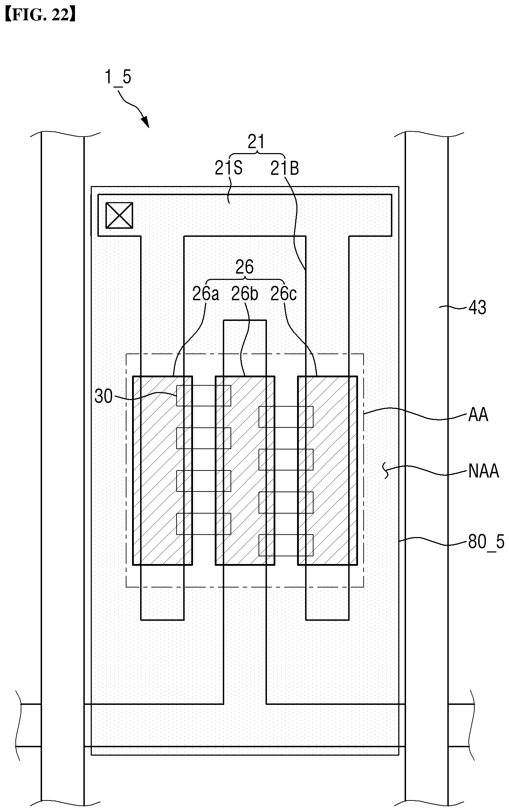

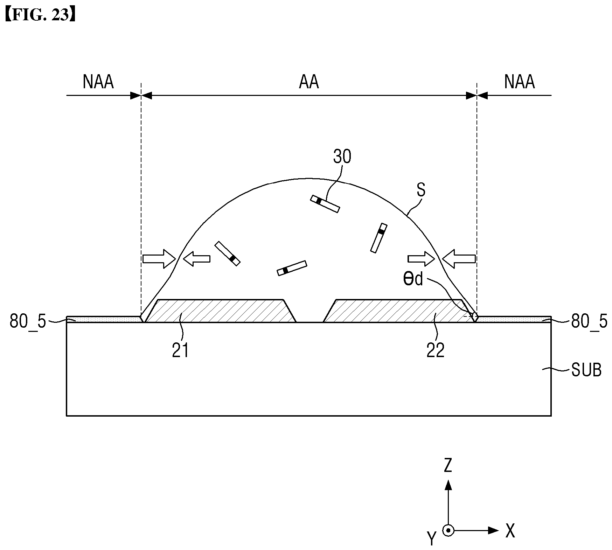

FIG. 22 is a plan view illustrating a display device according to yet another embodiment. FIG. 23 is a schematic cross-sectional view illustrating that an ink is sprayed onto the display device of FIG. 22.

Referring to FIGS. 22 and 23, a coating layer 80_5 of a display device 1_5 according to one embodiment may be disposed to overlap only a non-overlapping area NAA without overlapping an alignment area AA. When an ink S overlaps the alignment area AA, the ink S may be sprayed onto the electrodes 21 and 22 on which the coating layer 80_5 is not disposed and may spread to a boundary of a region in which the coating layer 80_5 is disposed. However, the coating layer 80_5 may prevent the ink S from spreading onto the coating layer 80_5 at the boundary, that is, the boundary between the alignment area AA and the non-alignment area NAA.

Specifically, as shown in FIG. 23, the coating layer 80_5 is disposed in only the non-alignment area NAA, and the ink S is disposed on the first electrode 21 and the second electrode 22 in the alignment area AA. The ink S disposed in the alignment area AA may spread in at least one direction without forming an interface with the coating layer 80_5.

When the ink S spreads to the boundary between the alignment area AA and the non-alignment area NAA, the ink S is in partial contact with the coating layer 80_5. Here, when the ink S contains a solvent of a first polarity and the coating layer 80_5 contains a material of a second polarity opposite to the first polarity, surface energy has a large value in an interface at which the ink S is in contact with the coating layer 80_5. In order to minimize surface energy on a surface of the ink S, the ink S may be moved to decrease an area in contact with the coating layer 80_5 in which the surface energy having a large value is formed. That is, when the ink S is in contact with the coating layer 80_5, a force is applied in a direction opposite to the one direction in which the ink S spreads in the alignment area AA. That is, the ink S does not move onto the coating layer 80_5 and is prevented from spreading at the boundary between the alignment area AA and the non-alignment area NAA, which is the boundary with the coating layer 80_5. Thus, the coating layer 80_5 may prevent the light emitting elements 30 from being moved to the non-alignment area NAA.

That is, the coating layer 80 contains a material having a polarity opposite to a polarity of the ink S to prevent the ink S from spreading to the non-alignment area NAA. This means that the ink S sprayed onto the alignment area AA may spread in the alignment area AA. The coating layer 80 according to one embodiment may include a first coating layer 81 and a second coating layer 82 which have different polarities. One of the first coating layer 81 and the second coating layer 82 may have the same polarity as the ink S, and the other one thereof may have a polarity opposite to the polarity of the ink S.

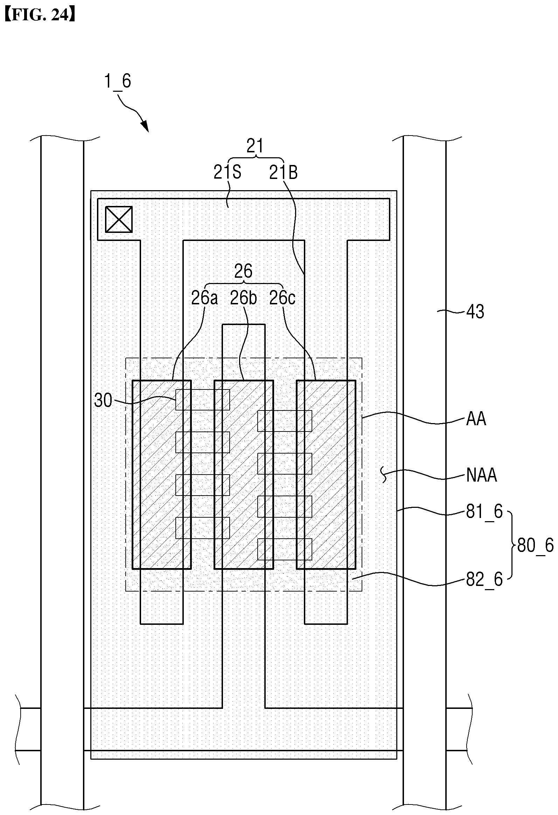

FIG. 24 is a plan view illustrating a display device according to yet another embodiment.

Referring to FIG. 24, a coating layer 80_6 of a display device 1_6 according to one embodiment may include a first coating layer 81_6 and a second coating layer 82_6. The first coating layer 81_6 may include a material having a first polarity, and the second coating layer 82_6 may include a material having a second polarity different from the first polarity. For example, the first coating layer 81_6 may include a hydrophobic material, and the second coating layer 82_6 may include a hydrophilic material. However, the present invention is not limited thereto, and the first polarity and the second polarity may be reversed.

In an example, in a manufacturing process of the display device 1_6, an ink S including the light emitting elements 30 may include a second polarity, for example, a hydrophilic solvent, and the display device 1_6 may include a second coating layer 82_6 overlapping an alignment area AA and a first coating layer 81_6 overlapping a non-alignment area NAA. The first coating layer 81_6 is disposed to substantially surround the second coating layer 82_6, and the second coating layer 82_6 is disposed to partially overlap a first electrode 21 and a second electrode 22 in the alignment area AA. Although not shown in the drawing, the second coating layer 82_6 may include an opening 80P exposing at least a portion of the electrodes 21 and 22, and a contact electrode 26 may be in contact with the electrodes 21 and 22 through the opening 80P. A description thereof is the same as described above.

The ink S including the light emitting elements 30 is sprayed onto the second coating layer 82_6 in the alignment area AA. The second coating layer 82_6 and the ink S may include materials or solvents having the same second polarity. The ink S may form a low surface energy on an interface with the second coating layer 82_6 to spread in at least one direction in the alignment area AA.

A boundary between the first coating layer 81_6 and the second coating layer 82_6 is formed at a boundary between the alignment area AA and the non-alignment area NAA. The ink S may spread in one direction in the alignment area AA and may be in partial contact with the first coating layer 81_6 at the boundary between the first coating layer 81_6 and the second coating layer 82_6.

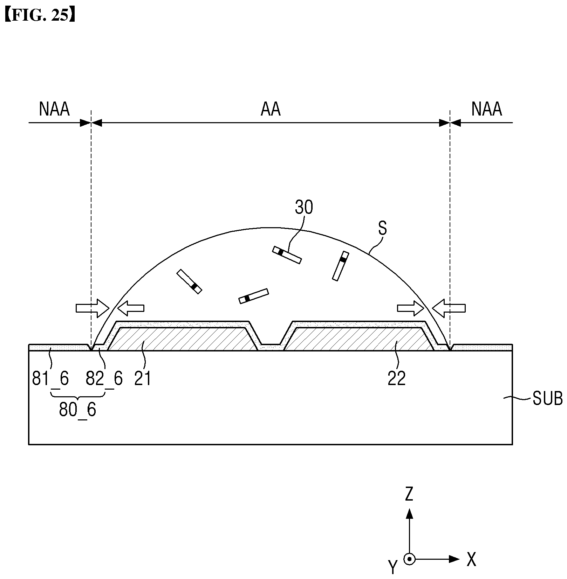

FIG. 25 is a schematic cross-sectional view illustrating that an ink is sprayed onto the display device of FIG. 24.

Referring to FIG. 25, the ink S may move on the second coating layer 82_6 and may be in contact with the first coating layer 81_6 at the boundary with the first coating layer 81_6. Since the ink S contains a solvent having a polarity opposite to the polarity of the first coating layer 81_6, a surface energy having a large value is formed on a surface in contact with the first coating layer 81_6. In order to minimize the surface energy on the surface of the ink S, a force is transmitted in a direction of minimizing an area of the surface in which surface energy having a large value is formed and which is in contact with the first coating layer 81_6. That is, the surface of the ink S is balanced due to forces in opposite directions at the boundary between the first coating layer 81_6 and the second coating layer 82_6 so that the ink S is prevented from spreading onto the first coating layer 81_6. Thus, the light emitting elements 30 are located in the alignment area AA on the second coating layer 82_6.

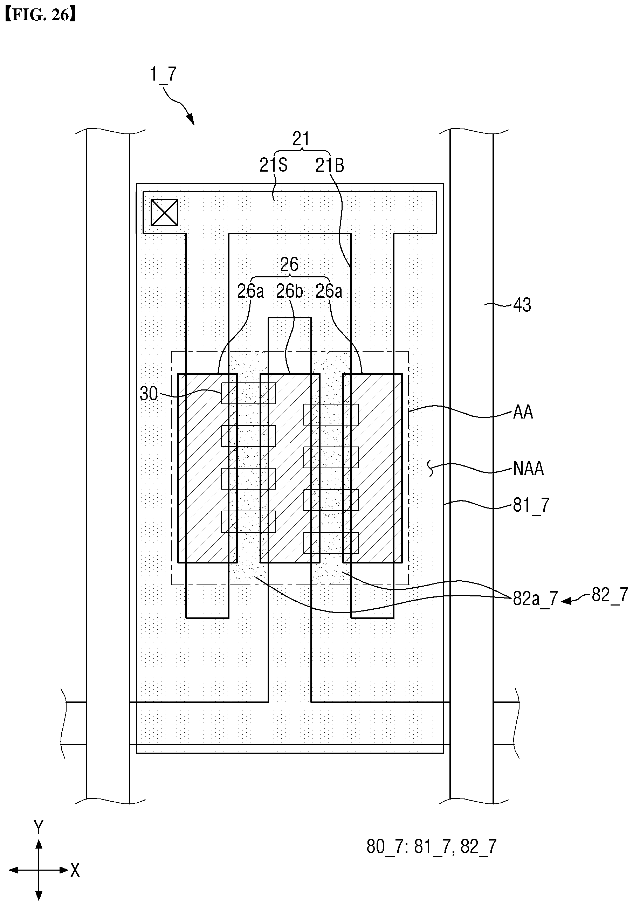

FIGS. 26 to 27 are plan views illustrating a display device according to yet another embodiment.

The second coating layer 82 may include a material having the same polarity as the solvent of the ink S. In this case, the surface energy of the ink S on the interface formed with the second coating layer 82 may be smaller than the surface energy thereof on the interface formed with the target substrate SUB or the electrodes 21 and 22 on which the coating layer 80 is not formed. In order to have a lower surface energy value, the ink S may move in a direction of increasing a surface in contact with the second coating layer 82. That is, an attractive force may be transferred to the ink S by the second coating layer 82. According to one example, the second coating layer 82 may be disposed in the alignment area AA and may include at least one coating pattern 82a, and the coating pattern 82a may at least be disposed between regions in which the electrodes 21 and 22 are opposite to each other.

Referring to FIG. 26 first, a coating layer 80_7 of a display device 1_7 may include a first coating layer 81_7 disposed in a non-alignment area NAA and a second coating layer 82_7 disposed in an alignment area AA, and the second coating layer 82_7 may include at least one coating pattern of 82a_7 and may be disposed between regions in which the first electrode 21 and the second electrode 22 are opposite to each other.

In FIG. 26, the second coating layer 82_7 may include two coating patterns 82a_7, and the two coating patterns 82a_7 may be disposed between the first electrode branch portion 21B and the second electrode branch portion 22B. The coating pattern 82a_7 has a shape extending in the second direction Y-axis and is disposed to be spaced apart in the first direction X-axis. The coating pattern 82a_7 of the second coating layer 82_7 may be disposed between the first electrode branch portion 21B and the second electrode branch portion 22B and may apply an attractive force to allow the ink S to have low surface energy. That is, the ink S may spread to allow an area of an interface formed with the second coating layer 82_7 on the target substrate SUB to be increased, and the light emitting elements 30 included in the ink S may be located on the second coating layer 82_7. Most of the light emitting elements 30 in the ink S may be located between the first electrode branch portion 21B and the second electrode branch portion 22B to be disposed between the electrodes 21 and 22.

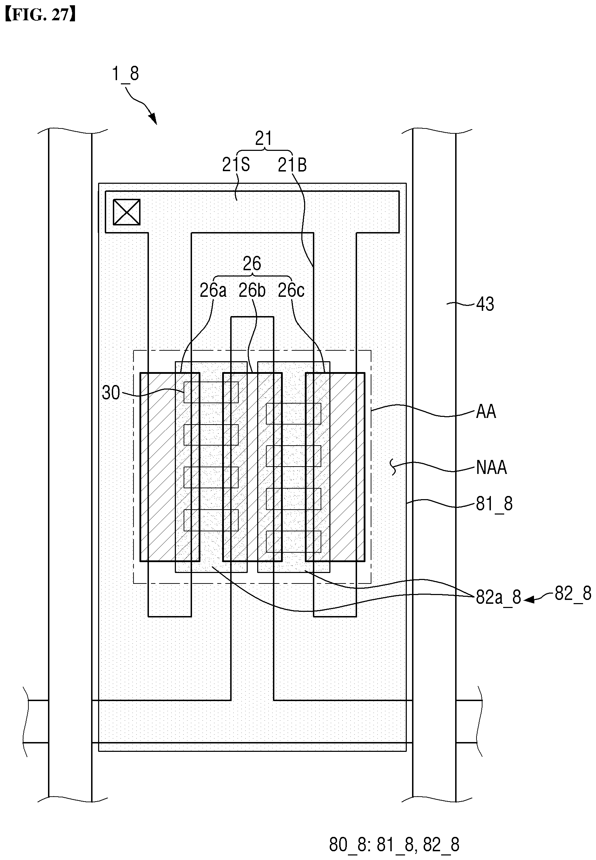

Referring to FIG. 27, when compared with FIG. 26, the coating pattern 82a_8 of the second coating layer 82_8 may have a relatively larger width and may partially overlap one facing side surfaces of the first electrode branch portion 21B and the second electrode branch portion 22B. A description of the coating pattern 82a_8 is the same as the above description, and thus a detailed description thereof will be omitted herein.

Meanwhile, the display device 1 may further include a light emitting element 30 having a structure different from the structure of the light emitting element 30 of FIG. 2.

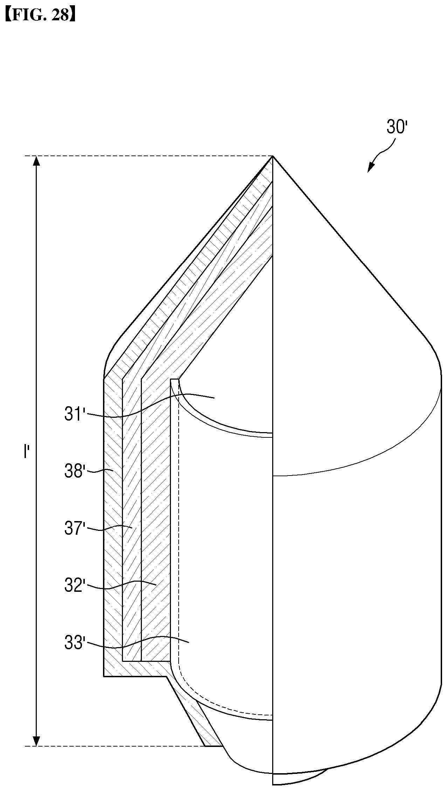

FIG. 28 is a schematic diagram of a light emitting element according to another embodiment.

Referring to FIG. 28, a light emitting element 30' may be formed such that a plurality of layers are not stacked in one direction and each of the plurality of layers surrounds an outer surface of another layer. The light emitting element 30' of FIG. 28 is the same as the light emitting element 30 of FIG. 2 except that shapes of the layers are partially different from each other. Hereinafter, the same content will be omitted and differences will be described.

According to one embodiment, a first conductivity type semiconductor 31' may extend in one direction and both end portions thereof may be formed to be inclined toward a central portion thereof. The first conductivity type semiconductor 31' of FIG. 28 may have a shape in which a rod-shaped or cylindrical main body and conical-shaped end portions on upper and lower portions of the main body are formed. An upper end portion of the main body may have a slope that is steeper than a slope of a lower end portion thereof.

An active layer 33' is disposed to surround an outer surface of the main body of the first conductivity type semiconductor 31'. The active layer 33' may have an annular shape extending in one direction. The active layer 33' may not be formed on upper and lower end portions of the first conductivity type semiconductor 31'. That is, the active layer 33' may be in contact with only a parallel side surface of the first conductivity type semiconductor 31'.

A second conductivity type semiconductor 32' is disposed to surround an outer surface of the active layer 33' and the upper end portion of the first conductivity type semiconductor 31'. The second conductivity type semiconductor 32' may include an annular-shaped main body extending in one direction and an upper end portion having a side surface formed to be inclined. That is, the second conductivity type semiconductor 32' may be in direct contact with a parallel side surface of the active layer 33' and an inclined upper end portion of the first conductivity type semiconductor 31'. However, the second conductivity type semiconductor 32' is not formed in the lower end portion of the first conductivity type semiconductor 31'.

An electrode material layer 37' is disposed to surround an outer surface of the second conductivity type semiconductor 32'. That is, a shape of the electrode material layer 37' may be substantially the same as a shape of the second conductivity type semiconductor 32'. That is, the electrode material layer 37' may be entirely in contact with the outer surface of the second conductivity type semiconductor 32'.

An insulating film 38' may be disposed to surround the electrode material layer 37' and the outer surface of the first conductivity type semiconductor 31'. The insulating film 38' may be in direct contact with, in addition to the electrode material layer 37', the lower end portion of the first conductivity type semiconductor 31' and exposed lower end portions of the active layer 33' and the second conductivity type semiconductor 32'.

## Claims

1. A display device (1) comprising:

    a substrate (SUB) in which a first area (AA) and a second area (NAA), which is an area other than the first area, are defined;
    a first electrode (21) and a second electrode (22) disposed and at least partially spaced apart from each other in the first area on the substrate;
    a first bank (41) disposed between the first electrode and the substrate;
    a second bank (42) disposed between the second electrode and the substrate;
    a first insulating layer (51) disposed to cover at least a portion of each of the first electrode and the second electrode on the substrate;
    a coating layer (80) disposed on the first insulating layer; and
    at least one light emitting element (30) disposed between the first electrode and the second electrode in the first area,
    wherein the coating layer and the first insulating layer include an opening exposing at least a portion of each of the first electrode and the second electrode, and

    the coating layer includes a first coating layer which is disposed in an area except for the opening and which includes a hydrophobic material.

2. The display device (1) of claim 1, wherein the first coating layer (81) is disposed to at least overlap the first area, and the light emitting element (30) is disposed in an area in which the opening (80P) is not disposed on the first coating layer.

3. The display device (1) of claim 2, wherein:

    the first coating layer (81) is disposed to cover the first electrode (21) and the second electrode (22) which are disposed in the first area; and
    the opening (80P) exposes at least a portion of the first electrode and the second electrode of the first area.

4. The display device (1) of claim 3, further comprising:

    a first contact electrode (26a) in contact with the first electrode (21) exposed through the opening; and
    a second contact electrode (26b) in contact with the second electrode (22) exposed through the opening,
    wherein the first contact electrode is in contact with one end portion of the light emitting element (30) and the second contact electrode is in contact with the other end portion thereof.

5. The display device (1) of claim 2, wherein the first coating layer (81) is disposed in a gap region in which the first electrode (21) and the second electrode (22) are spaced apart from each other and partially overlaps facing side surfaces of the first electrode and the second electrode, optionally wherein:

    the first coating layer includes at least one coating pattern (80a); and
    the coating pattern is disposed on a first side surface at which the first electrode is opposite to the second electrode and disposed on a second side surface at which the second electrode is opposite to the first electrode.

6. The display device of claim 1, wherein:

    at least a portion of each of the first electrode and the second electrode is disposed in the second area; and
    the first coating layer is disposed to cover the first electrode and the second electrode in the second area.

7. The display device of claim 6, wherein:

the coating layer includes a second coating layer disposed in the first area; and
the light emitting element is disposed on the second coating layer.

8. The display device of claim 7, wherein the first coating layer (81) includes a polymer containing fluorine.

9. The display device of claim 7 or claim 8, wherein:

the second coating layer is disposed to cover the first electrode and the second electrode which are disposed in the first area; and
the opening is disposed on the second coating layer and further includes a second opening exposing at least a portion of each of the first electrode and the second electrode of the first area.

10. The display device of any one of claims 7 to 9, wherein the second coating layer (82) is disposed in a gap region between the first electrode (21) and the second electrode (22) which are disposed in the first area, optionally wherein the second coating layer is disposed to partially overlap facing side surfaces of the first electrode and the second electrode.

11. A method of manufacturing a display device (1), comprising:

preparing a target substrate (SUB) in which a first area (AA) and a second area (NAA) which is an area other than the first area are defined, and a first electrode (21) and a second electrode (21) which are spaced apart from each other on the target substrate;
forming a coating layer (80) which is disposed on at least a partial area of the target substrate and which covers at least a portion of each of the first electrode and the second electrode; and
spraying an ink including a light emitting element (30) on the coating layer covering the first electrode and the second electrode and landing the light emitting element between the first electrode and the second electrode
wherein the target substrate further comprises:

a first bank (41) disposed between the first electrode and the substrate;
a second bank (42) disposed between the second electrode and the substrate; and
a first insulating layer (51) disposed to cover at least a portion of each of the first electrode and the second electrode on the substrate,
wherein the coating layer is disposed on the first insulating layer, and

the coating layer and the first insulating layer include an opening exposing at least a portion of each of the first electrode and the second electrode, and the coating layer includes a first coating layer which is disposed in an area except for the opening and which includes a hydrophobic material.

12. The method of claim 11, wherein the ink includes a hydrophilic solvent.

13. The method of claim 12, wherein the coating layer (80) contains a fluorine-based polymer.

14. The method of claim 12 or claim 13, wherein:

the ink is sprayed onto the coating layer (80) on the first electrode (21) and the second electrode (21); and
the ink sprayed onto the coating layer has a contact angle of 30 degrees or more between the ink and the coating layer, optionally wherein the landing of the light emitting element (30) includes:

applying alternating-current (AC) power to the first electrode and the second electrode to form an electric field in the ink; and
arranging the light emitting element between the first electrode and the second electrode due to the electric field.

**Patentansprüche**

1. Anzeigevorrichtung (1), Folgendes umfassend:

ein Substrat (SUB), wobei ein erster Bereich (AA) und ein zweiter Bereich (NAA), der ein anderer Bereich als der erste Bereich ist, definiert sind;
eine erste Elektrode (21) und eine zweite Elektrode (22), die in dem ersten Bereich auf dem Substrat angeordnet und mindestens teilweise voneinander beabstandet sind;
eine erste Bank (41), die zwischen der ersten Elektrode und dem Substrat angeordnet ist;
eine zweite Bank (42), die zwischen der zweiten Elektrode und dem Substrat angeordnet ist;
eine erste isolierende Schicht (51), die so angeordnet ist, dass sie mindestens einen Abschnitt jeder von der ersten Elektrode und der zweiten Elektrode auf dem Substrat bedeckt;
eine Beschichtungsschicht (80), die auf der ersten isolierenden Schicht angeordnet ist; und
mindestens ein lichtemittierendes Element (30), das zwischen der ersten Elektrode und der zweiten Elektrode in dem ersten Bereich angeordnet ist,

wobei die Beschichtungsschicht und die erste isolierende Schicht eine Öffnung einschließen, die mindestens einen Abschnitt jeder von der ersten Elektrode und der zweiten Elektrode freilegt, und

die Beschichtungsschicht eine erste Beschichtungsschicht einschließt, die in einem Bereich mit Ausnahme der Öffnung angeordnet ist und ein hydrophobes Material einschließt.

2. Anzeigevorrichtung (1) nach Anspruch 1, wobei die erste Beschichtungsschicht (81) so angeordnet ist, dass sie mindestens den ersten Bereich überlappt, und das lichtemittierende Element (30) in einem Bereich angeordnet ist, in dem die Öffnung (80P) nicht auf der ersten Beschichtungsschicht angeordnet ist.

3. Anzeigevorrichtung (1) nach Anspruch 2, wobei:

die erste Beschichtungsschicht (81) so angeordnet ist, dass sie die erste Elektrode (21) und die zweite Elektrode (22) bedeckt, die in dem ersten Bereich angeordnet sind; und

die Öffnung (80P) mindestens einen Teil der ersten Elektrode und der zweiten Elektrode des ersten Bereichs freilegt.

4. Anzeigevorrichtung (1) nach Anspruch 3, ferner Folgendes umfassend:

eine erste Kontaktelektrode (26a), die mit der ersten Elektrode (21) in Kontakt steht, die durch die Öffnung freiliegt; und

eine zweite Kontaktelektrode (26b), die mit der zweiten Elektrode (22) in Kontakt steht, die durch die Öffnung freiliegt,

wobei die erste Kontaktelektrode mit einem Endabschnitt des lichtemittierenden Elements (30) in Kontakt steht und die zweite Kontaktelektrode mit dem anderen Endabschnitt desselben in Kontakt steht.

5. Anzeigevorrichtung (1) nach Anspruch 2, wobei die erste Beschichtungsschicht (81) in einem Spaltbereich angeordnet ist, in dem die erste Elektrode (21) und die zweite Elektrode (22) voneinander beabstandet sind und teilweise gegenüber liegende Seitenflächen der ersten Elektrode und der zweiten Elektrode überlappt, wahlweise wobei:

die erste Beschichtungsschicht mindestens eine Beschichtungsstruktur (80a) einschließt; und

die Beschichtungsstruktur auf einer ersten Seitenfläche angeordnet ist, an welcher die erste Elektrode der zweiten Elektrode gegenüberliegt, und auf einer zweiten Seitenfläche angeordnet ist, an welcher die zweite Elektrode der ersten Elektrode gegenüberliegt.

6. Anzeigevorrichtung nach Anspruch 1, wobei:

mindestens ein Abschnitt jeder von der ersten Elektrode und der zweiten Elektrode in dem zweiten Bereich angeordnet ist; und

die erste Beschichtungsschicht so angeordnet ist, dass sie die erste Elektrode und die zweite Elektrode in dem zweiten Bereich bedeckt.

7. Anzeigevorrichtung nach Anspruch 6, wobei:

die Beschichtungsschicht eine zweite Beschichtungsschicht einschließt, die in dem ersten Bereich angeordnet ist; und

das lichtemittierende Element auf der zweiten Beschichtungsschicht angeordnet ist.

8. Anzeigevorrichtung nach Anspruch 7, wobei die erste Beschichtungsschicht (81) ein fluorhaltiges Polymer einschließt.

9. Anzeigevorrichtung nach Anspruch 7 oder Anspruch 8, wobei:

die zweite Beschichtungsschicht so angeordnet ist, dass sie die erste Elektrode und die zweite Elektrode bedeckt, die in dem ersten Bereich angeordnet sind; und

die Öffnung auf der zweiten Beschichtungsschicht angeordnet ist und ferner eine zweite Öffnung einschließt, die mindestens einen Abschnitt jeder von der ersten Elektrode und der zweiten Elektrode des ersten Bereichs freilegt.

10. Anzeigevorrichtung nach einem der Ansprüche 7 bis 9, wobei die zweite Beschichtungsschicht (82) in einem Spaltbereich zwischen der ersten Elektrode (21) und der zweiten Elektrode (22) angeordnet ist, die in dem ersten Bereich angeordnet sind, wahlweise wobei die zweite Beschichtungsschicht so angeordnet ist, dass sie gegenüber liegende Seitenflächen der ersten Elektrode und der zweiten Elektrode teilweise überlappt.

11. Verfahren des Herstellens einer Anzeigevorrichtung (1), Folgendes umfassend:

Vorbereiten eines Zielsubstrats (SUB), wobei ein erster Bereich (AA) und ein zweiter Bereich (NAA), der ein anderer Bereich als der erste Bereich ist, definiert werden, und eine erste Elektrode (21) und eine zweite Elektrode (21), die voneinander beabstandet sind, auf dem Zielsubstrat;

Bilden einer Beschichtungsschicht (80), die auf mindestens einem Teilbereich des Zielsubstrats angeordnet ist und die mindestens einen Abschnitt jeder von der ersten Elektrode und der zweiten Elektrode bedeckt; und

Sprühen einer Tinte, die ein lichtemittierendes Element (30) einschließt, auf die Beschichtungsschicht, welche die erste Elektrode und die zweite Elektrode bedeckt, und Aufsetzen des lichtemittierenden Elements zwischen der ersten Elektrode und der zweiten Elektrode wobei das Zielsubstrat ferner Folgendes umfasst:

eine erste Bank (41), die zwischen der ersten Elektrode und dem Substrat angeordnet ist;

eine zweite Bank (42), die zwischen der zweiten Elektrode und dem Substrat angeordnet ist; und

eine erste isolierende Schicht (51), die so angeordnet ist, dass sie mindestens einen Abschnitt jeder von der ersten Elektrode und der zweiten Elektrode auf dem Substrat bedeckt;

wobei die Beschichtungsschicht auf der ersten isolierenden Schicht angeordnet ist; und

die Beschichtungsschicht und die erste isolierende Schicht eine Öffnung einschließen, die mindestens einen Abschnitt jeder von der ersten Elektrode und der zweiten Elektrode freilegt, und die Beschichtungsschicht eine erste Beschichtungsschicht einschließt, die in einem Bereich mit Ausnahme der Öffnung angeordnet ist und ein hydrophobes Material einschließt.

**12.** Verfahren nach Anspruch 11, wobei die Tinte ein hydrophiles Lösungsmittel einschließt.

**13.** Verfahren nach Anspruch 12, wobei die Beschichtungsschicht (80) ein Polymer auf Fluorbasis enthält.

**14.** Verfahren nach Anspruch 12 oder Anspruch 13, wobei:

die Tinte auf die Beschichtungsschicht (80) auf der ersten Elektrode (21) und der zweiten Elektrode (21) gesprüht wird; und
die auf die Beschichtungsschicht gesprühte Tinte einen Kontaktwinkel von 30 Grad oder mehr zwischen der Tinte und der Beschichtungsschicht aufweist, wahlweise wobei das Aufsetzen des lichtemittierenden Elements (30) Folgendes einschließt:

Anlegen von Wechselstrom (AC) an die erste Elektrode und die zweite Elektrode, um ein elektrisches Feld in der Tinte zu bilden; und
Anordnen des lichtemittierenden Elements zwischen der ersten Elektrode und der zweiten Elektrode aufgrund des elektrischen Feldes.

**Revendications**

**1.** Dispositif d'affichage (1) comprenant :

un substrat (SUB) dans lequel une première zone (AA) et une seconde zone (NAA), qui est une zone autre que la première zone, sont définies ;
une première électrode (21) et une seconde électrode (22) disposées et au moins partiellement espacées l'une de l'autre dans la première zone sur le substrat ;
un premier banc (41) disposé entre la première électrode et le substrat ;
un second banc (42) disposé entre la seconde électrode et le substrat ;
une première couche isolante (51) disposée pour recouvrir au moins une portion de chacune de la première électrode et de la seconde électrode sur le substrat ;
une couche de revêtement (80) disposée sur la première couche isolante ; et
au moins un élément électroluminescent (30) disposé entre la première électrode et la seconde électrode dans la première zone,
dans lequel la couche de revêtement et la première couche isolante incluent une ouverture exposant au moins une portion de chacune de la première électrode et de la seconde électrode, et
la couche de revêtement inclut une première couche de revêtement qui est disposée dans une zone à l'exception de l'ouverture et qui inclut un matériau hydrophobe.

**2.** Dispositif d'affichage (1) selon la revendication 1, dans lequel la première couche de revêtement (81) est disposée pour au moins chevaucher la première zone, et l'élément électroluminescent (30) est disposé dans une zone dans laquelle l'ouverture (80P) n'est pas disposée sur la première couche de revêtement.

**3.** Dispositif d'affichage (1) selon la revendication 2, dans lequel :

la première couche de revêtement (81) est disposée pour recouvrir la première électrode (21) et la seconde électrode (22) qui sont disposées dans la première zone ; et

l'ouverture (80P) expose au moins une portion de la première électrode et de la seconde électrode de la première zone.

4. Dispositif d'affichage (1) selon la revendication 3, comprenant en outre :

une première électrode de contact (26a) en contact avec la première électrode (21) exposée à travers l'ouverture ; et
une seconde électrode de contact (26b) en contact avec la seconde électrode (22) exposée à travers l'ouverture,
dans lequel la première électrode de contact est en contact avec une portion d'extrémité de l'élément électroluminescent (30) et la seconde électrode de contact est en contact avec l'autre portion d'extrémité de celui-ci.

5. Dispositif d'affichage (1) selon la revendication 2, dans lequel la première couche de revêtement (81) est disposée dans une région d'espace dans laquelle la première électrode (21) et la seconde électrode (22) sont espacées l'une de l'autre et chevauche partiellement des surfaces latérales se faisant face de la première électrode et de la seconde électrode, facultativement dans lequel :

la première couche de revêtement inclut au moins un motif de revêtement (80a) ; et
le motif de revêtement est disposé sur une première surface latérale au niveau de laquelle la première électrode est opposée à la seconde électrode et disposé sur une seconde surface latérale au niveau de laquelle la seconde électrode est opposée à la première électrode.

6. Dispositif d'affichage selon la revendication 1, dans lequel :

au moins une portion de chacune de la première électrode et de la seconde électrode est disposée dans la seconde zone ; et
la première couche de revêtement est disposée pour recouvrir la première électrode et la seconde électrode dans la seconde zone.

7. Dispositif d'affichage selon la revendication 6, dans lequel :

la couche de revêtement inclut une seconde couche de revêtement disposée dans la première zone ; et
l'élément électroluminescent est disposé sur la seconde couche de revêtement.

8. Dispositif d'affichage selon la revendication 7, dans lequel la première couche de revêtement (81) inclut un polymère contenant du fluor.

9. Dispositif d'affichage selon la revendication 7 ou la revendication 8, dans lequel :

la seconde couche de revêtement est disposée pour recouvrir la première électrode et la seconde électrode qui sont disposées dans la première zone ; et
l'ouverture est disposée sur la seconde couche de revêtement et inclut en outre une seconde ouverture exposant au moins une portion de chacune de la première électrode et de la seconde électrode de la première zone.

10. Dispositif d'affichage selon l'une quelconque des revendications 7 à 9, dans lequel la seconde couche de revêtement (82) est disposée dans une région d'espace entre la première électrode (21) et la seconde électrode (22) qui sont disposées dans la première zone, facultativement dans lequel la seconde couche de revêtement est disposée pour partiellement chevaucher des surfaces latérales se faisant face de la première électrode et de la seconde électrode.

11. Procédé de fabrication d'un dispositif d'affichage (1), comprenant les étapes consistant à :

préparer un substrat cible (SUB) dans lequel une première zone (AA) et une seconde zone (NAA) qui est une zone autre que la première zone sont définies, et une première électrode (21) et une seconde électrode (21) qui sont espacées l'une de l'autre sur le substrat cible ;
former une couche de revêtement (80) qui est disposée sur au moins une zone partielle du substrat cible et qui recouvre au moins une portion de chacune de la première électrode et de la seconde électrode ; et
pulvériser une encre incluant un élément électroluminescent (30) sur la couche de revêtement recouvrant la première électrode et la seconde électrode et poser l'élément électroluminescent entre la première électrode et la seconde électrode
dans lequel le substrat cible comprend en outre :

un premier banc (41) disposé entre la première électrode et le substrat ;
un second banc (42) disposé entre la seconde électrode et le substrat ; et
une première couche isolante (51) disposée pour recouvrir au moins une portion de chacune de la première électrode et de la seconde électrode sur le substrat,
dans lequel la couche de revêtement est disposée sur la première couche isolante, et

la couche de revêtement et la première couche isolante incluent une ouverture exposant au moins une portion de chacune de la première électrode et de la seconde électrode, et la couche de revêtement inclut une première couche de revêtement qui est disposée dans une zone à l'exception de l'ouverture et qui inclut un matériau hydrophobe.

12. Procédé selon la revendication 11, dans lequel l'encre inclut un solvant hydrophile.

13. Procédé selon la revendication 12, dans lequel la couche de revêtement (80) contient un polymère à base de fluor.

14. Procédé selon la revendication 12 ou la revendication 13, dans lequel

l'encre est pulvérisée sur la couche de revêtement (80) sur la première électrode (21) et la seconde électrode (21) ; et l'encre pulvérisée sur la couche de revêtement présente un angle de contact de 30 degrés ou plus entre l'encre et la couche de revêtement, facultativement dans lequel la pose de l'élément électroluminescent (30) inclut :

l'application d'une puissance de courant alternatif (AC) à la première électrode et la seconde électrode pour former un champ électrique dans l'encre ; et la mise en place de l'élément électroluminescent entre la première électrode et la seconde électrode en raison du champ électrique.

【FIG. 1】

【FIG. 2】

【FIG. 3】

【FIG. 4】

【FIG. 5】

【FIG. 6】

【FIG. 7】

【FIG. 8】

【FIG. 9】

【FIG. 10】

40: 41, 42, 43

**[FIG. 11]**

S100

PREPARE TARGET SUBSTRATE, AND FIRST ELECTRODE AND
SECOND ELECTRODE WHICH ARE DISPOSED TO BE SPACED APART
FROM EACH OTHER ON TARGET SUBSTRATE

S200

FORM COATING LAYER WHICH IS DISPOSED ON AT LEAST
A PARTIAL REGION OF TARGET SUBSTRATE AND COVERS AT LEAST
A PORTION OF EACH OF THE FIRST ELECTRODE AND SECOND ELECTRODE

S300

SPRAY INK INCLUDING LIGHT EMITTING ELEMENTS ONTO COATING LAYER
AND LAND LIGHT EMITTING ELEMENTS BETWEEN FIRST ELECTRODE
AND SECOND ELECTRODE

【FIG. 12】

【FIG. 13】

【FIG. 14】

【FIG. 15】

【FIG. 16】

【FIG. 17】

【FIG. 18】

【FIG. 19】

【FIG. 20】

【FIG. 21】

【FIG. 22】

【FIG. 23】

【FIG. 24】

【FIG. 25】

【FIG. 26】

80_7: 81_7, 82_7

【FIG. 27】

80_8: 81_8, 82_8

【FIG. 28】

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- US 2018019369 A1
- US 2016211245 A1
- US 2002005294 A1

### Non-patent literature cited in the description

- High-Efficient Chip to Wafer Self-Alignment and Bonding Applicable to MEMS-IC Flexible Integration. **JIAN LE et al.** IEEE Sensors Journal. IEEE, vol. 13